# EUROPEAN PATENT APPLICATION

(11) **EP 4 761 493 A2**
(43) Date of publication of application: **17.06.2026**
(21) Application number: 25211850.0
(22) Date of filing: 28.10.2025
(51) Int. Cl.: H10B 12/00

(54) **SEMICONDUCTOR DEVICES**

(30) Priority: 15.11.2024 KR 20240162971
(71) Applicant: Samsung Electronics Co., Ltd., Suwon-si, Gyeonggi-do 16677 (KR)
(72) Inventor: SHIN, Seungmin, 16677 Suwon-si (KR); KUH, Bongjin, 16677 Suwon-si (KR); KIM, Naeyeon, 16677 Suwon-si (KR); SEO, Hyeyeong, 16677 Suwon-si (KR); OH, Jungmin, 16677 Suwon-si (KR); LEE, Jinkwan, 16677 Suwon-si (KR)
(74) Representative: Marks & Clerk LLP

(57) **Abstract**

The semiconductor device includes an etch stop pattern on a substrate and extending in a vertical direction and in a first direction parallel to the upper surface of the substrate; channels spaced apart from each other in the vertical direction and at least partially extending through the etch stop pattern; gate electrodes extending in the first direction, respectively surrounding first end portions in the second direction of the channels, and respectively including gate electrodes; isolation patterns disposed between the gate electrodes; a bit line electrically connected to the channels and extending in the vertical direction along sidewalls in the second direction of the first end portions of the channels; and capacitors respectively on second end portions in the second direction of the channels, wherein the etch stop pattern and the gate electrodes are spaced apart from each other by the isolation patterns and do not contact each other.

## Description

### TECHNICAL FIELD

Example embodiments of the inventive concept relate to a semiconductor device. More particularly, example embodiments of the inventive concept relate to a three-dimensional (3D) memory device.

### DISCUSSION OF RELATED ART

A DRAM device includes word lines, bit lines, channels and capacitors. In order to increase the integration degree of the DRAM device, the word lines, the bit lines, the channels and the capacitors should be efficiently arranged.

### SUMMARY

Example embodiments of the inventive concept provide a semiconductor device having enhanced electrical characteristics.

According to example embodiments of the inventive concept, there is provided a semiconductor device. The semiconductor device may include: an etch stop pattern on a substrate and extending in a vertical direction perpendicular to an upper surface of the substrate, the etch stop pattern comprising a metal oxide; channels spaced apart from each other in the vertical direction, each extending in a first horizontal direction that is parallel to the upper surface of the substrate, each of the channels extending partly into or extending fully through the etch stop pattern; gate electrodes, each gate electrode surrounding a corresponding one of the channels; isolation patterns, each isolation pattern disposed between a corresponding pair of adjacent ones of the gate electrodes; a bit line extending in the vertical direction and along sidewalls of first end portions of the channels; and capacitors at sidewalls of respective second end portions of the channels. The etch stop pattern and the gate electrodes are spaced apart from each other by the isolation patterns.

According to example embodiments of the inventive concept, there is provided a semiconductor device. The semiconductor device may include: an etch stop pattern on a substrate and extending in a vertical direction perpendicular to an upper surface of the substrate; a channel extending in a first horizontal direction that is parallel to the upper surface of the substrate, the channel extending partly into or extending fully through the etch stop pattern; a gate electrode surrounding the channel; a bit line extending in the vertical direction and along a sidewall of a first end portion of the channel; and a capacitor at a sidewall of a second end portion of the channel. The etch stop pattern includes a first portion and a second portion, the first portion surrounds the channel, and the second portion is integrally connected to the first portion. The first portion of the etch stop pattern protrudes toward the capacitor in the first horizontal direction from the second portion of the etch stop pattern.

According to example embodiments of the inventive concept, there is provided a semiconductor device. The semiconductor device may include: channels on a substrate, each extending in a first horizontal direction that is parallel to an upper surface of the substrate, the channels disposed spaced apart from each other in a vertical direction perpendicular to the upper surface of the substrate; gate electrodes each extending in a second horizontal direction that intersects the first horizontal direction, each of the gate electrodes surrounding a corresponding one of first end portions of the channels; isolation patterns disposed between the gate electrodes; a bit line extending in the vertical direction and along sidewalls of the first end portions of the channels; conductive contacts, each conductive contact in contact with a corresponding one of second end portions of the channels and including a semiconductor material doped with charge carrier impurities; capacitors, each capacitor including a first capacitor electrode in contact with the conductive contacts; and an etch stop pattern disposed between the isolation patterns and the capacitors, the etch stop pattern surrounding the second end portions of the channels and including a metal oxide. Each of the channels has the maximum width in the vertical direction, each of the conductive contacts has the maximum width in the vertical direction, and each of the first capacitor electrodes has a first distance between upper and lower surfaces in the vertical direction. The maximum width of the conductive contacts in the vertical direction is greater than the maximum width of the channel in the vertical direction and the first distance. The maximum width of the channel in the vertical direction is smaller than the maximum width of the conductive contacts in the vertical direction and the first distance.

The semiconductor device in accordance with example embodiments may include an etch stop pattern that serves as an etch stop line. Consequently, even with increased aspect ratios of the semiconductor device, uniform characteristics of the capacitor structure may be achieved between its upper and lower portions.

At least some of the above and other features of the invention are set out in the claims.

### BRIEF DESCRIPTION OF THE DRAWINGS

FIGS. 1 to 6 are a perspective view, a horizontal cross-sectional view and vertical cross-sectional views illustrating a semiconductor device in accordance with example embodiments.
FIGS. 7 to 55 are vertical cross-sectional views and horizontal cross-sectional views illustrating a method of manufacturing a semiconductor device in accordance with example embodiments.
FIG. 56 is a vertical cross-sectional view illustrating a semiconductor device in accordance with example embodiments.
FIGS. 57 and 58 are vertical cross-sectional views illustrating a method of manufacturing a semiconductor device in accordance with example embodiments.
FIG. 59 is a vertical cross-sectional view illustrating a semiconductor device in accordance with example embodiments.
FIG. 60 is a vertical cross-sectional view illustrating a semiconductor device in accordance with example embodiments.
FIGS. 61 to 67 are vertical cross-sectional views illustrating a method of manufacturing a semiconductor device in accordance with example embodiments.
FIG. 68 is a vertical cross-sectional view illustrating a semiconductor device in accordance with example embodiments.
FIGS. 69 and 70 are vertical cross-sectional views illustrating a method of manufacturing a semiconductor device in accordance with example embodiments.

### DETAILED DESCRIPTION OF THE EMBODIMENTS

The above and other aspects and features of the semiconductor devices and the methods of manufacturing the same in accordance with example embodiments will become readily understood from detailed descriptions that follow, with reference to the accompanying drawings. It will be understood that, although ordinal numbers such as "first," "second," and/or "third" may be used herein as labels to distinguish between various elements and/or processes and will be understood not be limited by these terms. In addition, a term that is referenced with a particular ordinal number (e.g., "first" in a particular claim) may be referenced elsewhere with a different ordinal number (e.g., "second" in the specification or another claim).

First and second directions D1 and D2 may be reference directions that are substantially parallel to an upper surface of the substrate, which intersect each other. Third direction D3 may refer to a direction perpendicular to the first and second directions D1 and D2. In example embodiments, the first and second directions D1 and D2 may be substantially perpendicular to each other. Each of the first to third directions D1, D2 and D3 may include not only a direction shown in the drawings but also a direction opposite thereto. For ease of description, first and second direction D1 and D2 may be considered as horizontal directions and third direction D3 may be considered a vertical direction. Similarly, spatially relative terms, such as "beneath," "below," "lower," "above," "upper," "top," "bottom," "front," "rear," and the like, may be used herein for ease of description to describe positional relationships, such as illustrated in the figures, for example. It will be understood that the spatially relative terms encompass different orientations of the device in addition to the orientation depicted in the figures.

Throughout the specification, when a component is described as "including" a particular element or group of elements, it is to be understood that the component is formed of only the element or the group of elements, or the element or group of elements may be combined with additional elements to form the component, unless the context indicates otherwise. The term "consisting of," on the other hand, indicates that a component is formed only of the element(s) listed.

It will be understood that when an element is referred to as being "connected" or "coupled" to or "on" another element, it can be directly connected or coupled to or on the other element or intervening elements may be present. In contrast, when an element is referred to as being "directly connected" or "directly coupled" to another element, or as "contacting" or "in contact with" another element (or using any form of the word "contact"), there are no intervening elements present at the point of contact.

Items described in the singular herein may be provided in plural, as can be seen, for example, in the drawings. Thus, the description of a single item that is provided in plural should be understood to be applicable to the remaining plurality of items unless context indicates otherwise.

Terms such as "same," "equal," "constant," "flat," etc. as used herein, are intended to encompass meanings that include typical variations resulting from conventional manufacturing processes and/or accommodate tolerances acceptable in the manufacturing process of the semiconductor device, unless the context or other statements indicate otherwise. For example, 'same' and 'equal' may encompass identicality or near identicality. The term "substantially" may be used herein to emphasize this meaning.

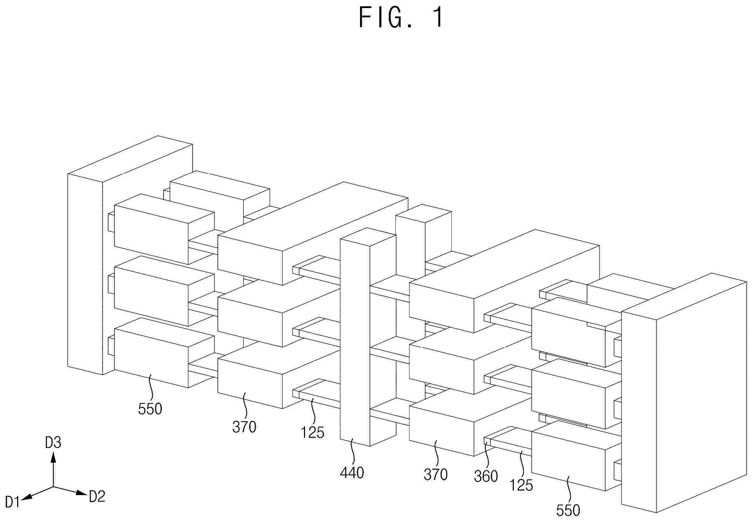

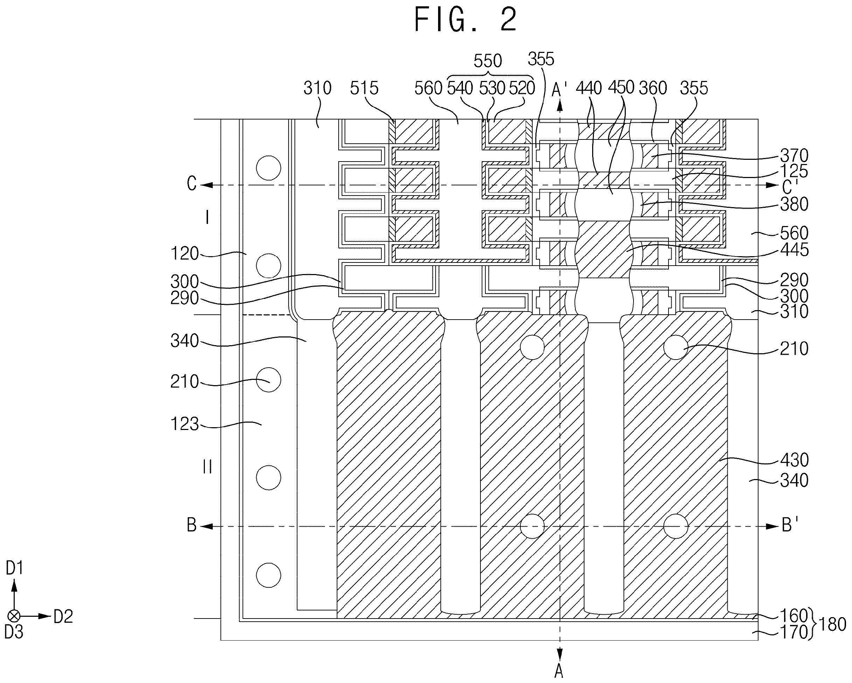

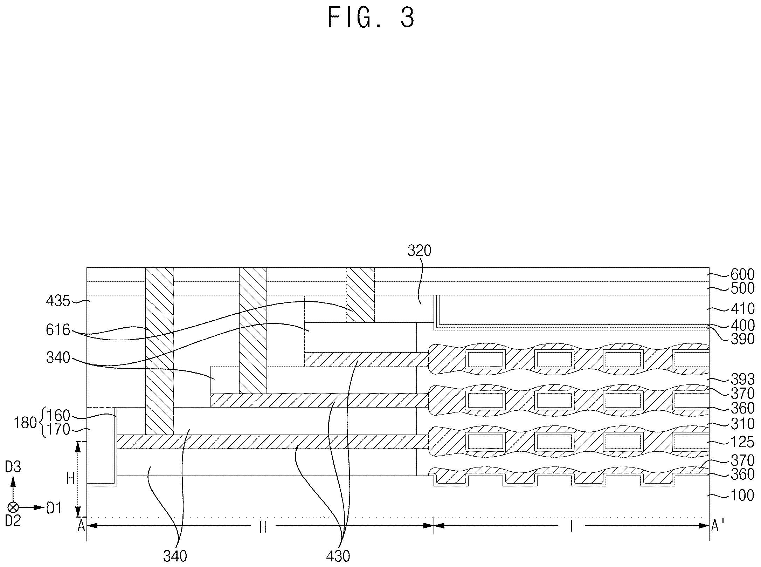

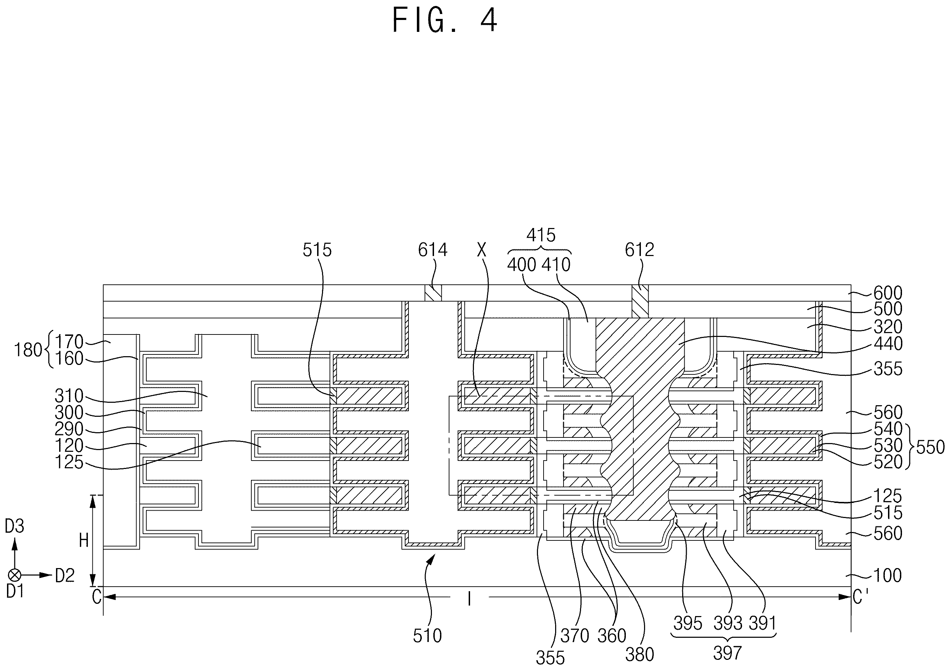

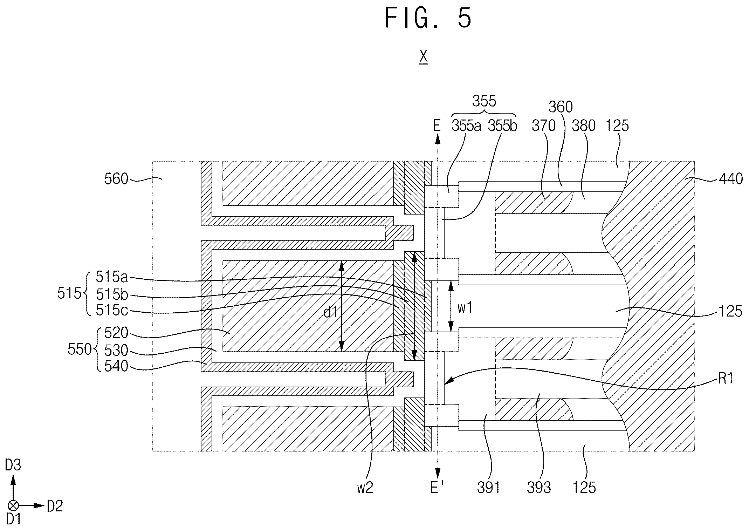

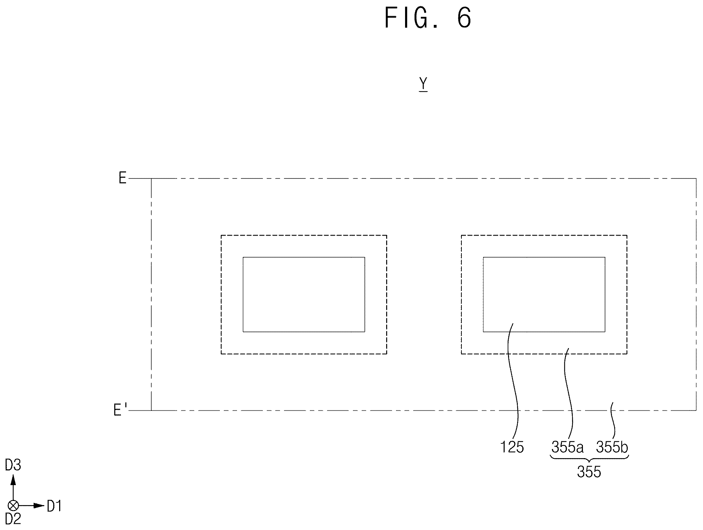

FIGS. 1 to 6 are a perspective view, a horizontal cross-sectional view and vertical cross-sectional views illustrating a semiconductor device in accordance with example embodiments. Particularly, FIG. 1 is a perspective view illustrating main portions of the semiconductor device in a simplified form. FIG. 2 is a horizontal cross-sectional view taken at height H identified in FIGS. 3 and 4. FIGS. 3 and 4 are vertical cross-sectional views respectively taken along lines A-A' and C-C' of FIG. 2. FIG. 5 is an enlarged cross-sectional view of a region X of FIG.4. FIG. 6 is a vertical cross-sectional view of a region Y taken along lines E-E' of FIG. 5.

Referring to FIGS. 1 to 6, the semiconductor device may include a memory cell region in which memory cells are formed and a peripheral circuit region in which circuits for applying electrical signals to the memory cells are formed. The memory cell region may include memory cell block regions each of which may include memory cells. The memory cell block regions may be arranged in each of the first and second directions D1 and D2, and may be separated from each other by a first division structure 180.

The first division structure 180 may contact an upper surface of the substrate 100 of the memory cell region, and may have a lattice shape (e.g., a grid structure) in a plan view (a top down view). For example, with respect to a plan view, the first division structure 180 may surround each of the memory cell block regions (e.g., each of the memory cell block regions may be formed in a corresponding cell of the lattice shape of the first division structure 180). In an example embodiment, the first division structure 180 may include a first division pattern 160 and a second division pattern 170 covering a sidewall and a lower surface of the first division pattern 160. The first division pattern 160 may include an insulating nitride, e.g., silicon nitride, and the second division pattern 170 may include an oxide, e.g., silicon oxide. Throughout the specification, the first division structure 180 including the first and second division patterns 160, 170, may be isolation patterns or an isolation structure.

Each of the memory cell block regions may include first and second regions I and II. The first region I may be a memory cell array region in which a memory cell array of the memory cells is formed, and the second region II may be a pad region or an extension region in which contact plugs for transferring electrical signals to the memory cell array and conductive pads contacting the contact plugs are formed.

In example embodiments, the second region II may be disposed at just one side or two second regions II may be formed on opposite sides in the first direction D1 of the first region I. FIG. 2 shows a portion of the memory cell block region including a portion of each of the first and second regions I and II.

The semiconductor device may include channels 125, gate structures, bit lines 440, etch stop patterns 355, ohmic contacts 515, capacitor structures, conductive pads 430 and first to third contact plugs 612, 614 and 616 on the substrate 100.

Additionally, the semiconductor device may include a dummy bit line 445, a first division structure 180, a third division structure, a fourth division structure 397, a fifth division structure 415, support patterns 210, semiconductor layers 120, semiconductor patterns 123, a second mask 320, an eighth division pattern 340, second and third insulating interlayers 435 and 600, and a capping layer 500 on the substrate 100.

As used herein, the term "dummy" is used to refer to a component that has the same as or similar structure and shape as other components but does not have a substantial function (e.g., to convey information). The "dummy" element may only exist as a pattern in the device. In some instances, a "dummy" element may be electrically floated, or may be connected to various voltage sources but otherwise not provide the same functionality of the non-dummy element it represents. For example, a dummy bit line may not connect to memory cells, or may have dummy memory cells connected to it (where no data is read from the dummy memory cells).

The substrate 100 may include a semiconductor material, e.g., silicon, germanium, silicon-germanium, etc., or a III-V group compound semiconductor, such as GaP, GaAs, GaSb, etc. In an example embodiment, the substrate 100 may be a silicon-on-insulator (SOI) substrate or a germanium-on-insulator (GOI) substrate.

The channels 125 may respectively (or individually) extend in the second direction D2 on the first region I of the substrate 100, may be spaced apart from each other in the first and second direction D1 and D2, and may be spaced apart from each other in the third direction D3. Ones of the channels 125 arranged in the first direction D1 at substantially the same level may form each of channel columns, and the channel columns may be spaced apart from each other in the second and third directions D2 and D3. Ones of the channel columns spaced apart from each other in the second direction D2 at substantially the same level may form each of channel arrays, and the channel arrays may be spaced apart from each other in the third direction D3.

The semiconductor layers 120 may extend in the first direction D1 at each of opposite sides in the second direction D2 of the first region I of the substrate 100. In example embodiments, the semiconductor layers 120 and the channels 125 may be disposed at substantially the same height from the upper surface of the substrate 100.

The semiconductor patterns 123 may extend in the first direction D1 at each of opposite sides in the second direction D2 of the second region II of the substrate 100. The semiconductor patterns 123 may contact and be connected to the semiconductor layers 120.

Each of the channels 125, the semiconductor layers 120 and the semiconductor patterns 123 may include substantially the same material, e.g., a semiconductor material such as silicon.

The gate structures may extend in a first direction D1 and may be spaced apart from each other in second and third directions D2 and D3. In example embodiments, each of the gate structures may extend in the first direction D1 and surrounding upper and lower surfaces and opposite sidewalls in the first direction D1 of first end portions in the second direction D2 of the channels 125 included in a corresponding channel column on the first region I of the substrate 100. The gate structures may serve as word lines of the semiconductor device.

The gate structures may include gate electrodes 370, gate insulation patterns 360 and gate masks 380. In example embodiments, each of the gate structures may include the gate insulation patterns 360 respectively covering surfaces of the first end portions of the channels 125 included in the corresponding channel column, and a gate electrode 370 and a gate mask 380 surrounding the gate insulation patterns 360.

The gate insulation patterns 360 may cover the upper and lower surfaces and the opposite sidewalls in the first direction D1 of the first end portions of the channels 125 and a portion of the upper surface of the substrate 100. Each gate insulation pattern 360 may take the form of a tube having a corresponding one of the channels formed therein (e.g., a channel 125 may extend through the tube-shaped gate insulating pattern 360. The gate insulation patterns 360 may include an oxide, e.g., silicon oxide.

The gate electrode 370 may extend in the first direction D1 and may cover upper and lower surfaces and opposite sidewalls in the first direction D1 of portions of the gate insulation patterns 360 arranged in the first direction D1. The gate electrode 370 may include a conductive material, e.g., a metal, a metal nitride, a metal silicide, etc.

The gate mask 380 may extend in the first direction D1, may cover upper and lower surfaces and opposite sidewalls in the first direction D1 of portions of the gate insulation patterns 360 arranged in the first direction D1, and may contact a sidewall in the second direction D2 of the gate electrode 370. The gate mask 380 may include an insulating nitride, e.g., silicon nitride.

The conductive pads 430 may respectively extend in the first direction D1 on the second region II of the substrate 100, and may be spaced apart from each other in the second direction D2. In example embodiments, at least a portion of the conductive pads 430 may be disposed at substantially the same height as the gate electrodes 370, and may contact sidewalls in the first direction D1 of the gate electrodes 370 to be electrically connected thereto. In example embodiments, the conductive pads 430 may overlap the gate structures and the channels 125 in the first direction D1.

In example embodiments, the conductive pads 430 may be spaced apart from each other in the third direction D3, and lengths in the first direction D1 of the conductive pads 430 may decrease from a lowermost one to an uppermost one thereof in a stepwise manner. Thus, the conductive pads 430 disposed in the third direction D3 may form a staircase structure.

The conductive pads 430 may include a conductive material, e.g., a metal, a metal nitride, a metal silicide, doped polysilicon, etc.

In example embodiments, the third division structure may include first and second insulation patterns 290 and 300 and a seventh division pattern 310.

Hereinafter, for convenience of explanation, the channels 125 adjacent to the semiconductor layers 120 in the second direction D2 will be referred to as first channels.

The third division structure may fill spaces between the semiconductor layers 120 stacked in the third direction D3, between the first channels stacked in the third direction D3, between the upper surface of the substrate 100 and a lowermost semiconductor layer 120, between the upper surface of the substrate 100 and a lowermost first channel, between an uppermost semiconductor layer 120 and the second mask 320, and between uppermost first channel and the second mask 320. Additionally, the third division structure may fill spaces between the semiconductor layers 120 and the first channels adjacent to each other in the second direction D2. Furthermore, the third division structure may fill spaces between the first channels adjacent to each other in the first direction D1 on the memory cell region of the substrate 100.

The first and second insulation patterns 290 and 300 may be sequentially stacked on surfaces of the substrate 100, the first division structure 180, the semiconductor layers 120, and the first channels, and the seventh division pattern 310 may be disposed on the second insulation pattern 300 and fill other portions of the remaining spaces.

The first insulation pattern 290 and the seventh division pattern 310 may include an oxide, e.g., silicon oxide, and the second insulation pattern 300 may include an insulating nitride, e.g., silicon nitride. For example, the third division structure may include silicon oxide, silicon nitride, or a combination thereof.

The etch stop patterns 355 may fill spaces between second end portions in the second direction D2 of the channels 125. For example, an etch stop pattern 355 may have a plate shape extending in the first and third directions D1 and D3, and the channels 125 may extend through the etch stop pattern 355 having the plate shape. For example, each of the channels 125 may extend partly into or extend fully through a corresponding one of the etch stop patterns 355.

The etch stop pattern 355 may include first portions 355a respectively surrounding the channels 125 and a second portion 355b surrounding the first portions 355a.

In example embodiments, sidewalls in the second direction D2 of the first portions 355a of the etch stop pattern 355 that are facing the bit lines 440 may protrude further in the second direction D2 as compared to a sidewall in the second direction D2 of the second portion 355b of the etch stop pattern 355 that faces the bit lines 440. Accordingly, a first recess R1 may be formed at a first sidewall in the second direction D2 of the etch stop pattern 355 that faces the bit lines 440.

In example embodiments, a cross-section of each of the first portions 355a of the etch stop pattern 355 in a plane extending in the first and third directions D1 and D3 may have, for example, a rectangular ring shape.

For example, the etch stop pattern 355 may include first portions 355a and a second portion 355b. Each of the first portions 355a may surround a corresponding one of the channels 125. The second portion 355b may connect the first portions 355a to each other. The first portions 355a of the etch stop pattern 355 may protrude toward the bit line 440 in the second direction D2 from the second portion 355b of the etch stop pattern 355. The second portion 355b may be integrally formed with the first portions 355a (e.g., form a single continuous homogenous body).

In example embodiments, the first portions 355a of the etch stop pattern 355 may not protrude toward the bit line 440 in the second direction D2 from the second portion 355b of the etch stop pattern 355. That is, a sidewall in the second direction D2 of the first portion 355a facing the bit line 440 and a sidewall in the second direction D2 of the second portion 355b facing the bit line 440 may align to each other in the third direction D3.

The etch stop patterns 355 may include, for example, a high-k metal oxide having a dielectric constant higher than silicon oxide, such as hafnium oxide (HfO₂), zirconium oxide (ZrO₂), hafnium zirconium oxide (HfZrO), aluminum oxide (Al₂O₃), etc. In the case of silicon nitride layer or silicon carbonitride layer, carbon atoms or nitrogen atoms may diffuse into the channel 125, degrading electrical characteristics of the channel 125. In contrast, since the high-k metal oxide does not include carbon atoms or nitrogen atoms, degradation of electrical characteristics of the channel 125 may be prevented or suppressed.

In example embodiments, the minimum thickness of the etch stop pattern 355 in the first direction D1 may be 5nm or more to 10nm or less.

The fourth division structure (or fourth isolation pattern) 397 may fill spaces between the gate structures stacked in the third direction D3, between the channels 125 stacked in the third direction D3, between the upper surface of the substrate 100 and a lowermost gate structure, between the upper surface of the substrate 100 and a lowermost channel 125, between an uppermost gate structure the second mask 320, and between an uppermost channel 125 and the second mask 320. Additionally, the fourth division structure 397 may fill spaces between the channels 125 adjacent to each other in the second direction D2. Furthermore, the fourth division structure 397 may be formed between the channels 125 adjacent to each other in the first direction D1 on the memory cell region of the substrate 100.

In example embodiments, the fourth division structure 397 may include first filling patterns 391, second filling patterns 393, and a third insulation pattern 395. Each of the first filling patterns 391, the second filling patterns 393, and the third insulation pattern 395 may include an oxide, for example, silicon oxide, and may be merged with each other.

A first filling pattern 391 may fill a space between the etch stop pattern 355 and the gate electrodes 370. Accordingly, since the gate electrodes 370 may not be in contact with the etch stop pattern 355 in the second direction D2, leakage current may be reduced as compared to when the gate electrodes 370 contact the etch stop pattern 355 including the high-k metal oxide.

A second filling pattern 393 may fill spaces between the gate electrodes 370 and the gate masks 380.

The third insulation pattern 395 may extend in the first direction D1 while covering a surface of the gate insulation pattern 360 on the upper surface of the substrate 100 and the gate masks 380 covering the same, and a lower sidewall of the second filling pattern 393.

In example embodiments, the eighth division pattern 340 may be disposed on the second region II of the substrate 100, and may fill spaces between the conductive pads 430 stacked in the third direction D3, between the semiconductor patterns 123 stacked in the third direction D3, between the upper surface of the substrate 100 and a lowermost conductive pad 430, between the upper surface of the substrate 100 and a lowermost semiconductor pattern 123, between an uppermost conductive pad 430 and the second mask 320, and between an uppermost semiconductor pattern 123 and the second mask 320.

In example embodiments, lengths in the first direction D1 of portions of the eighth division pattern 340 disposed on respective levels may decrease from a lowermost one to an uppermost one in a stepwise manner, and thus a stack structure including the portions of the eighth division pattern 340 may be a staircase structure. In example embodiments, a portion of the eighth division pattern 340 on a corresponding conductive pad 430 may collectively form one step layer, and a sidewall in the first direction D1 of the portion of the eighth division pattern 340 may be aligned with a sidewall in the first direction D1 of the corresponding conductive pad 430 in the third direction D3.

The eighth division pattern 340 may include an insulating nitride, e.g., silicon nitride.

The support patterns 210 may be spaced apart from each other in the first direction D1 at each of opposite sides in the second direction D2 of the first region I of the substrate 100, and may be spaced apart from each other in the first and second directions D1 and D2 on the second region II of the substrate 100. Each of the support patterns 210 may extend through the semiconductor layers 120, the third division structure, the eighth division pattern 340 and the conductive pads 430 to contact the upper surface of the substrate 100.

The support patterns 210 may include an insulating nitride, e.g., silicon nitride, and may be merged with the eighth division pattern 340.

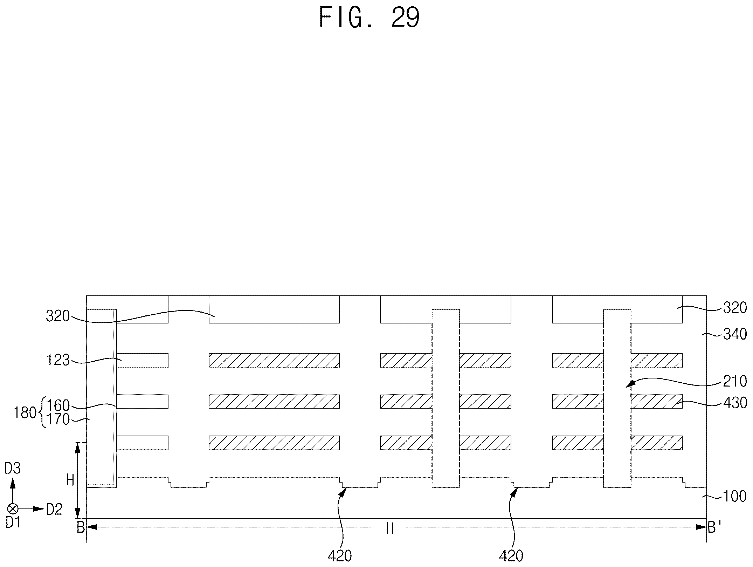

The second mask 320 may be disposed on the third division structure and the eighth division pattern 340 on the first and second regions I and II of the substrate 100. Referring to FIGS. 1 to 6 together with FIG. 29, the eighth division pattern 340 may cover sidewalls of the second mask 320, and accordingly, uppermost surfaces of the eighth division pattern 340 and an upper surface of the second mask 320 may be disposed at substantially the same height. The second mask 320 may include an insulating nitride, e.g., silicon nitride.

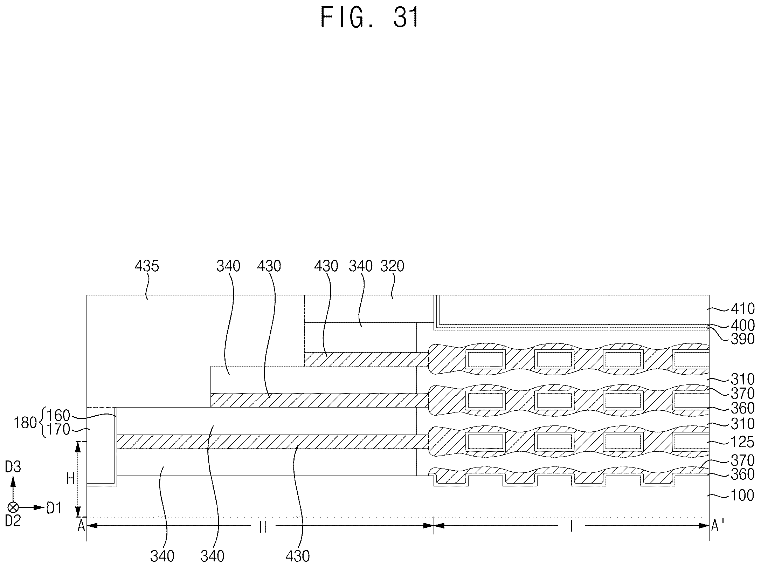

The second insulating interlayer 435 may be disposed on the eighth division pattern 340 on the second region II of the substrate 100. Referring to FIGS. 1 to 6 together with FIG. 31, an upper surface of the second insulating interlayer 435 and the upper surface of the second mask 320 may be disposed at substantially the same height. The second insulating interlayer 435 may include an oxide, e.g., silicon oxide.

The fifth division structure 415 may extend in the first direction D1 between the channels 125 adjacent to each other in the second direction D2. In example embodiments, a lower portion of the fifth division structure 415 may be disposed on the third insulation pattern 395 on the first region I of the substrate 100. In example embodiments, an upper surface of an upper portion of the fifth division structure 415 and the upper surface of the second mask 320 may be disposed at substantially the same height.

The fifth division structure 415 may include a ninth division pattern 410 and a fourth insulation pattern 400 covering sidewalls and a lower surface thereof. The fourth insulation pattern 400 may include an insulating nitride, for example, silicon nitride, and the ninth division pattern 410 may include an oxide, for example, silicon oxide.

The bit lines 440 may extend in the third direction D3 partially through the fifth division structure 415 extending in the first direction D1 on the first region I of the substrate 100, and may be spaced apart from each other in the first direction D1. Eleventh division patterns 450 including an oxide, e.g., silicon oxide may respectively extend partially through the fifth division structure 415 between ones of the bit lines 440 neighboring in the first direction D1, so that the bit lines 440 may be separated from each other by the eleventh division patterns 450. The dummy bit line 445 may be disposed on a portion of the first region I adjacent to the second region II of the substrate 100.

In example embodiments, each of the bit lines 440 may contact the channels 125 that are arranged along the third direction D3 and disposed at opposite sides in the second direction D2 of the corresponding bit line 440, and the dummy bit line 445 may contact the channels 125 that are arranged along the third direction D3 and disposed at opposite sides in the second direction D2 of the dummy bit line 445. Each of the bit lines 440 and the dummy bit line 445 may also contact sidewalls in the second direction D2 of the gate insulation patterns 360 and the gate masks 380 surrounding the first end portions of the channels 125.

In an example embodiment, each of the bit line 440 and the dummy bit line 445 may include, e.g., polysilicon doped with n-type impurities. Alternatively, each of the bit lines 440 and the dummy bit line 445 may include, e.g., a metal, a metal nitride, a metal silicide, etc.

The ohmic contacts 515 may be respectively disposed on sidewalls of the second end portions in the second direction D2 of the channels 125. Accordingly, the ohmic contacts 515 may be spaced apart from each other in the first and second directions D1 and D2 at the same height from the upper surface of the substrate 100, and may be spaced apart from each other in the third direction D3.

In example embodiments, the ohmic contacts 515 may partially cover a second sidewall in the second direction D2 of the etch stop pattern 355.

In example embodiments, the maximum cross-sectional area of the ohmic contact 515 of a vertical cross-section extending in the first and third directions D1 and D3 may be greater than the maximum cross-sectional area of the channel 125 of a vertical cross-section extending in the first and third directions D1 and D3.

In example embodiments, an ohmic contact (or conductive contact) 515 may include first, second, and third portions 515a, 515b and 515c sequentially stacked on a sidewall in the second direction D2 of the second end of the channel 125. The first portion 515a of the ohmic contact 515 may overlap with the etch stop pattern 355 in the third direction D3. The first, second, and third portions 515a, 515b and 515c may be formed integrally such that the first, second, and third portions 515a, 515b and 515c form a single continuous homogenous body.

In example embodiments, a third area of a vertical cross-section of the third portion 515c of the ohmic contact 515 corresponding to a third plane extending in the first and third directions D1 and D3 may be greater than the maximum vertical cross-sectional area of the channel 125 corresponding to a fourth plane extending in the first and third directions D1 and D3. In example embodiments, a second area of a vertical cross-section of the second portion 515b of the ohmic contact 515 corresponding to a second plane extending in the first and third directions D1 and D3 may be greater than the third area of the vertical cross-section of the third portion 515c of the ohmic contact 515 corresponding to the third plane extending in the first and third directions D1 and D3. In example embodiments, the first area of the vertical cross-section of the first portion 515a of the ohmic contact 515 corresponding to a first plane extending in the first and third directions D1 and D3 may be substantially the same as the maximum vertical cross-sectional area of the channel 125 corresponding to the fourth plane extending in the first and third directions D1 and D3. In example embodiments, areas may be largest in the order of the second area, the third area, and the first area, and the first area may be substantially the same as the maximum vertical cross-sectional area of the channel 125. In some examples, the area of contact of the third portion 515c of the ohmic contact 515 with the second capacitor electrode may be greater than the area of contact of the first portion 515a of the ohmic contact 515 with the channel 125, and both of these areas may be smaller than the second area of the vertical cross section of second portion 515b of the ohmic contact 515 corresponding to the fourth plane extending in the first and third directions D1 and D3.

In addition, although the drawings illustrate the ohmic contact 515 including the first to third portions 515a, 515b and 515c, the concept of the present invention is not limited thereto. For example, the ohmic contact 515 may not include the first portion 515a and/or the third portion 515c.

In example embodiments, the ohmic contacts 515 may be formed of a semiconductor material, for example, silicon doped with n-type impurities or p-type impurities (charge carrier impurities). Each of the conductive contacts 515 may be formed of a semiconductor material having n-type or p-type impurities. In semiconductor technology, if a semiconductor contains both p-type and n-type impurities, the conductivity-type of the semiconductor will be determined by which type of impurity is in greater concentration. Therefore, if a semiconductor has both p-type and n-type impurities, the net conductivity type will be determined by the dominant impurity concentration. As used herein, a semiconductor region of a "first conductivity-type" denotes that the dominant impurities in the semiconductor region is (or are) a first conductivity-type impurity, and a "concentration of the first conductivity-type" in the semiconductor region (or a "doping concentration") refers the net concentration of the impurities in the semiconductor region (i.e., (the amount of first conductivity-type impurities minus the amount of second conductivity-type impurities) / the volume of the semiconductor region).

The ohmic contact 515 may be a conductive contact or a conductive pattern that enables a non-rectifying electrical junction between two conductive materials (e.g., between the channel 125 and the first capacitor electrode 520, between the ohmic contact 515 and the channel 125, and/or between the ohmic contact 515 and the first capacitor electrode 520), wherein the current-voltage characteristic is substantially linear and consistent with Ohm's law. An ohmic contact may allow bidirectional flow of charge carriers without significant rectification, voltage threshold effects, or excessive power dissipation. Preferably, it may allow substantially low electrical resistance to minimize energy loss and ensure efficient electrical conduction between the interfacing conductive regions.

The capacitor structures may include capacitors 550 and plate electrodes 560, and the capacitors 550 may include first and second capacitor electrodes 520 and 540 and dielectric patterns 530. In example embodiments, a capacitor 550 may include a first capacitor electrode 520, a portion of a dielectric pattern 530 and a portion of a second capacitor electrode 540, wherein the portions of the dielectric pattern 530 and the second capacitor electrode 540 are sequentially stacked on a surface of the first capacitor electrode 520. In example embodiments, a capacitor structure may include a plate electrode 560 and capacitors 550 disposed on opposite sidewalls in the second direction D2 of the plate electrode 560.

The first capacitor electrodes 520 may be respectively disposed on the sidewalls of the ohmic contacts 515 and may respectively extend in the second direction D2. Accordingly, the first capacitor electrodes 520 may be spaced apart from each other in the first and second directions D1 and D2 at the same height from the upper surface of the substrate 100, and may be spaced apart from each other in the third direction D3.

In example embodiments, upper and lower surfaces of the first capacitor electrode 520 may have a first maximum distance d1 in the third direction D3, the channel 125 may have a first maximum width w1 in the third direction D3, and the ohmic contact 515 may have a second maximum width w2 in the third direction D3. Among the first maximum distance d1, the first maximum width w1, and the second maximum width w2, the second maximum width w2 may be the greatest and the first maximum width w1 may be the smallest.

In example embodiments, among a sixth area of a cross-section of the first capacitor electrode 520 corresponding to a plane extending in the first and third directions D1 and D3, the second area of the cross-section of the second portion 515b of the ohmic contact 515 in the second plane determined by the first and third directions D1 and D3, and the maximum cross sectional area of the channel 125 in the fourth plane extending in the first and third directions D1 and D3, the second area may be the greatest and the maximum cross sectional area of the channel 125 may be the smallest.

In example embodiments, the dielectric pattern 530 and the second capacitor electrode 540 may be disposed in spaces between the first capacitor electrodes 520 disposed in the third direction D3 on the first region I of the substrate 100, between a lowermost first capacitor electrode 520 and the upper surface of the substrate 100, and between an uppermost first capacitor electrode 520 and the second mask 320. In example embodiments, the dielectric pattern 530 and the second capacitor electrode 540 may be sequentially stacked on surfaces of the first capacitor electrodes 520, surfaces of the ohmic contacts 515, and the second sidewalls in the second direction D2 of the etch stop patterns 355.

In example embodiments, the dielectric pattern 530 may contact the second sidewalls of the etch stop patterns 355.

The plate electrodes 560 may fill the remaining portion of the above spaces and spaces between channels 125 adjacent to each other in the second direction D2. Accordingly, each of the plate electrodes 560 may include a vertical extension portion extending in the third direction D3 and horizontal extension portions respectively extending in the second direction D2 from opposite sidewalls of the vertical extension portion. Additionally, each of the capacitors 550 and the plate electrodes 560 may extend in the first direction D1 on the first region I of the substrate 100.

In example embodiments, the capacitor structures may extend through the capping layer 500 and the third division structure. Accordingly, the capacitor structures may be disposed on the opposite side of the bit lines 440 in the second direction D2 with respect to the channels 125.

Each of the first and second capacitor electrodes 520 and 540 may include a metal, e.g., titanium, tantalum, etc., or a metal nitride, e.g., titanium nitride, tantalum nitride, etc., each of the dielectric patterns 530 may include a metal oxide having a high dielectric constant, e.g., hafnium oxide, zirconium oxide, etc., and each of the plate electrodes 560 may include, e.g., doped or undoped silicon-germanium.

The word line and the bit line 440 extending in the first and second directions D1 and D2, respectively, the channel 125 surrounded by the word line and contacting the bit line 440, and the capacitor 550 electrically connected to the channel 125 on the first region I of the substrate 100 may collectively form each of the memory cells, and the memory cells may be disposed in each of the first to third directions D1, D2 and D3 on the first region I of the substrate 100.

The capping layer 500 may be disposed on the second mask 320, the second interlayer insulating layer 435, and the fifth division structure 415 on the substrate 100, and may cover upper sidewalls of the capacitor structures. The capping layer 500 may include an insulating nitride, for example, silicon nitride.

The third insulating interlayer 600 may be disposed on the capping layer 500.

The first contact plugs 612 may extend through the third insulating interlayer 600 and the capping layer 500 to respectively contact upper surfaces of the bit lines 440. The second contact plugs 614 may extend through the third insulating interlayer 600 to respectively contact upper surfaces of the plate electrodes 560 of the capacitor structure. The third contact plug 616 may extend through the third insulating interlayer 600, the capping layer 500, the second mask 320 and the eighth division pattern 340 or extend through the third insulating interlayer 600, the capping layer 500 and the second insulating interlayer 435 to contact upper surfaces of the conductive pads 430.

In the semiconductor device, the sixth area of the first capacitor electrode 520 may be formed larger than the maximum area of the channel 125. Accordingly, a surface area of the first capacitor electrode 520 may increase, resulting in an increase of capacitance of the capacitor structure.

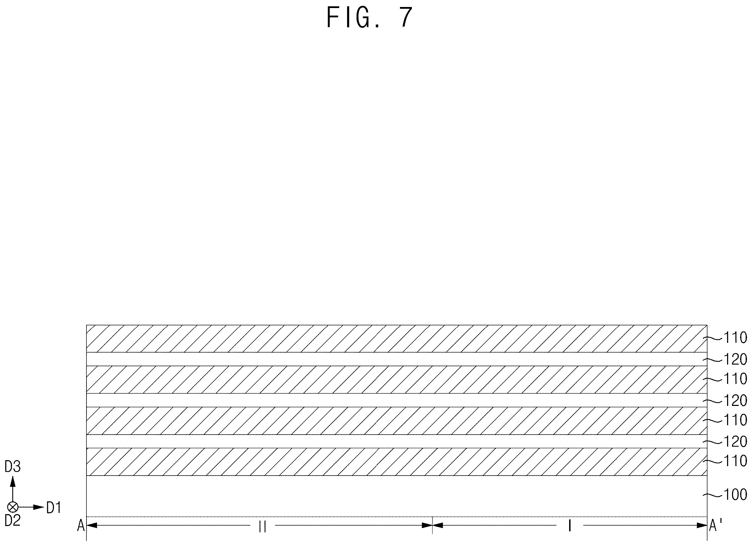

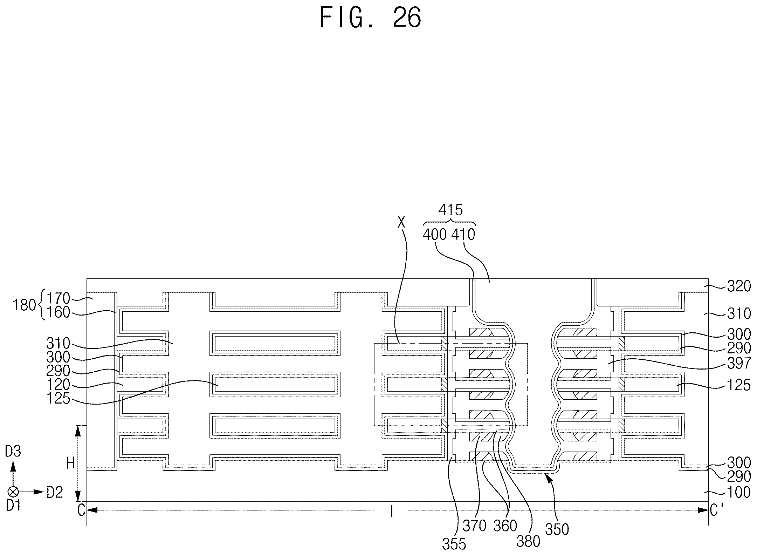

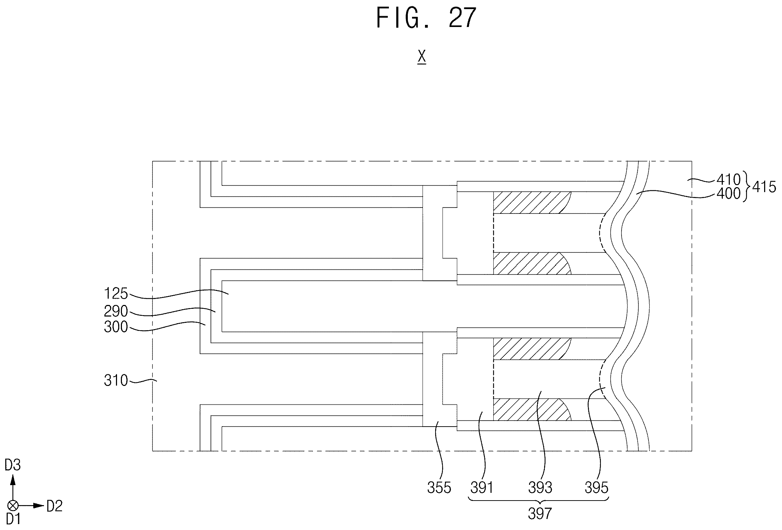

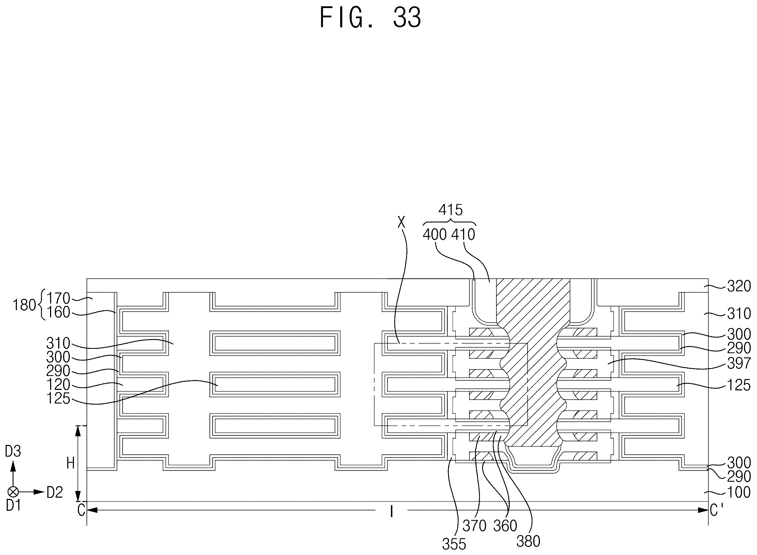

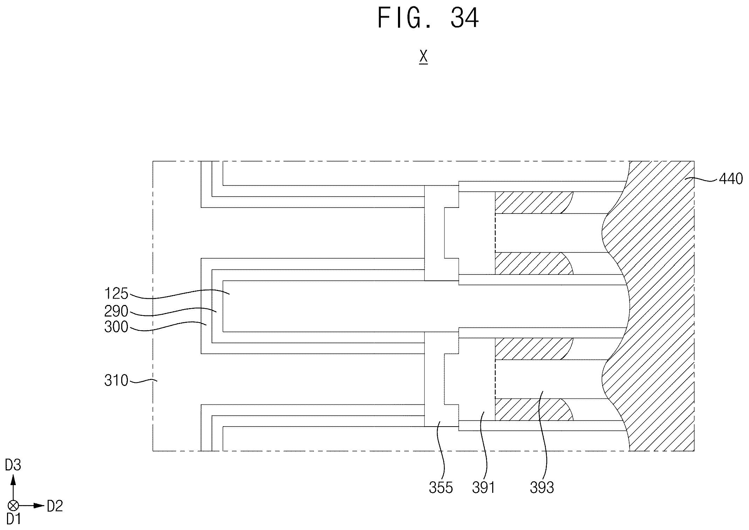

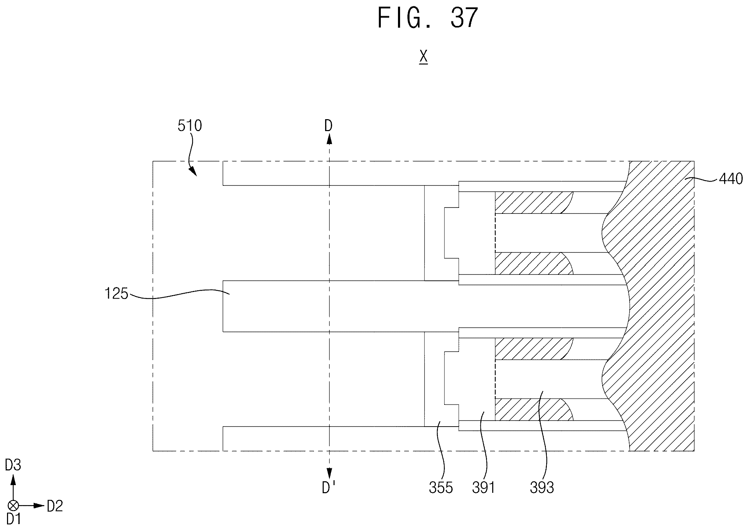

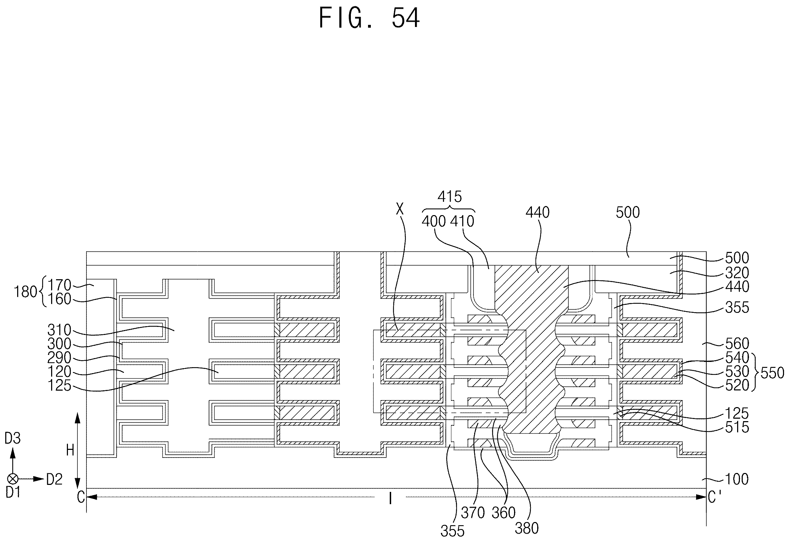

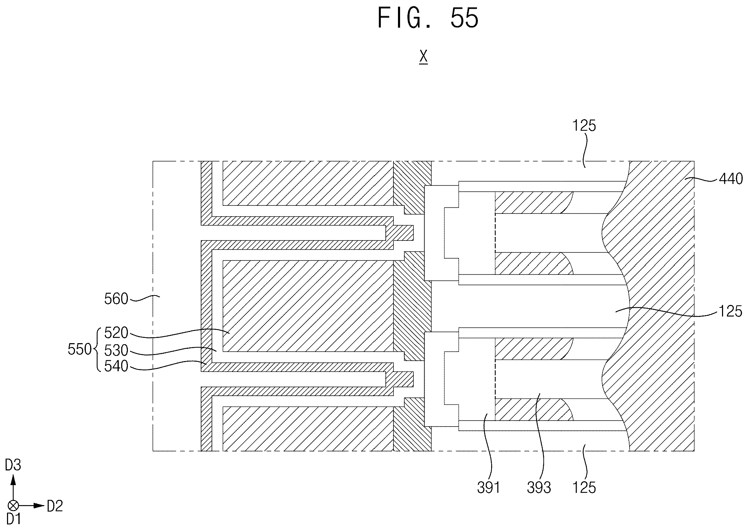

FIGS. 7 to 55 are vertical cross-sectional views and horizontal cross-sectional views illustrating a method of manufacturing a semiconductor device in accordance with example embodiments.

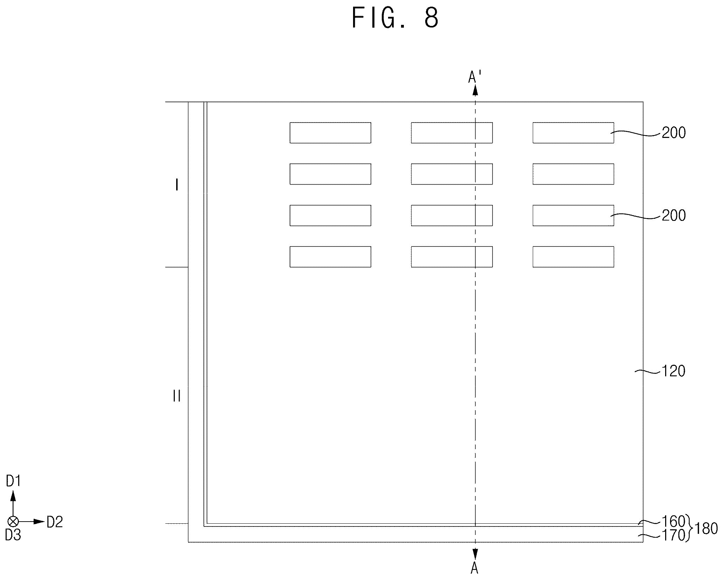

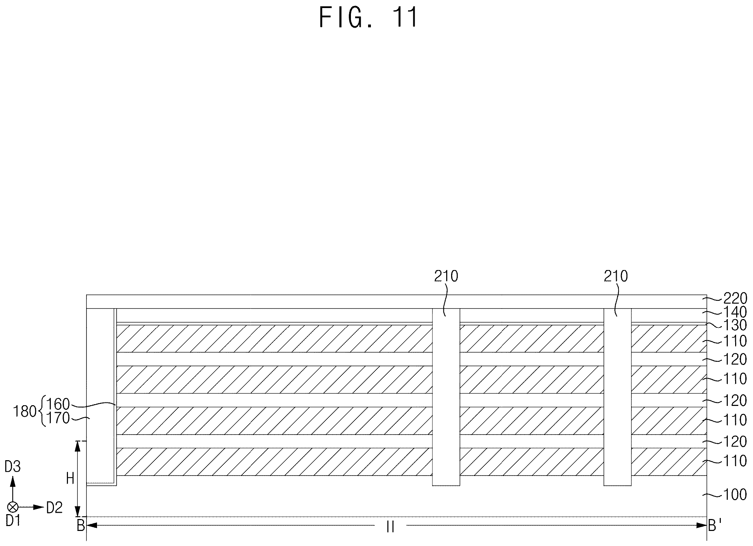

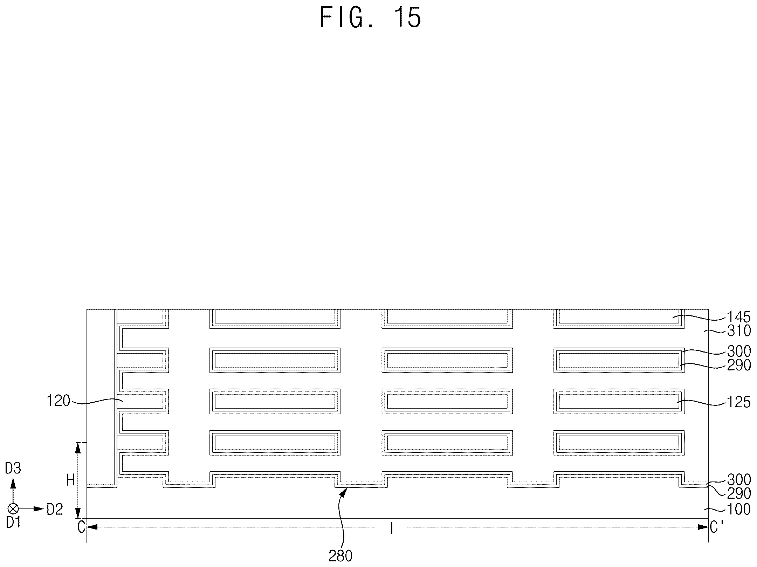

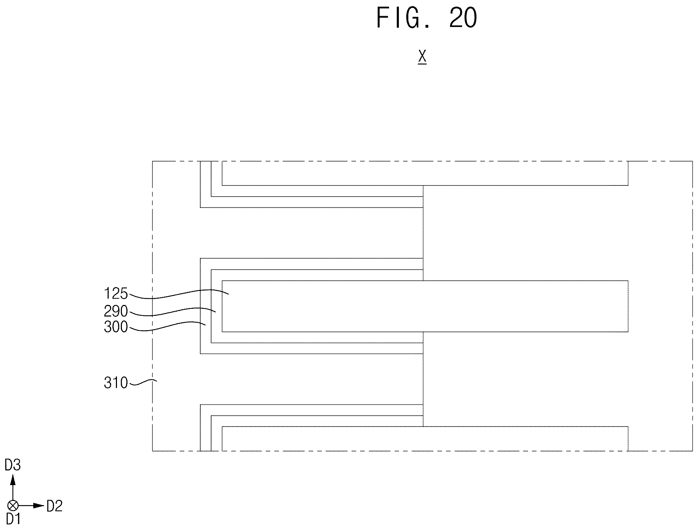

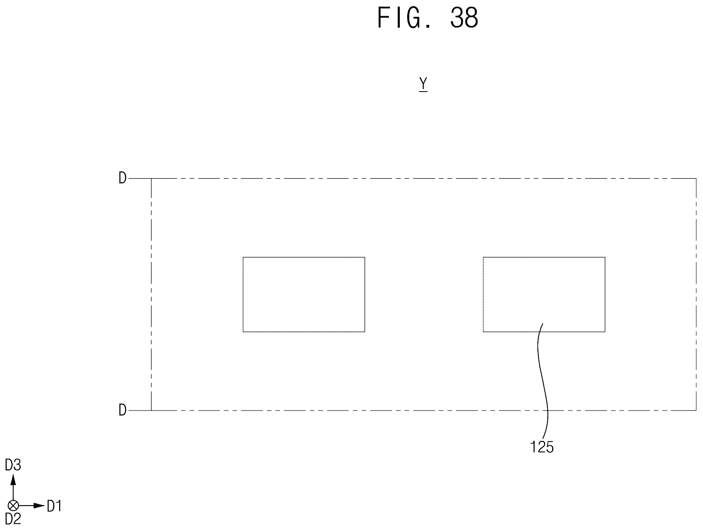

Particularly, FIGS. 8, 10, 12, 14, 16, 18, 25, 28, 30, 32, 35 and 53 are horizontal cross-sectional views at heights H of corresponding vertical cross-sectional views. FIGS. 7, 9 and 31 are vertical cross-sectional views taken along lines A-A' of corresponding horizontal cross-sectional views. FIGS. 11, 13, 17 and 29 are vertical cross-sectional views taken along lines B-B' of corresponding horizontal cross-sectional views. FIGS. 15, 19, 26, 33, 36 and 54 are vertical cross-sectional views taken along lines C-C' of corresponding horizontal cross-sectional views. FIGS. 20-24, 27, 34, 37, 39, 41, 43, 45-47, 49 and 51-52 are enlarged cross-sectional views about a region X of corresponding vertical cross-sectional views. FIGS. 38, 40, 42, 44, 48 and 50 are enlarged cross-sectional views about a region Y taken along lines D-D' of corresponding enlarged cross-sectional views of the region X.

Referring to FIG. 7, sacrificial layers 110 and semiconductor layers 120 may be alternately and repeatedly stacked on a substrate 100 including first and second regions I and II to form a mold layer.

FIG. 7 shows that the sacrificial layers 110 and the semiconductor layers 120 are stacked at four levels and three levels, respectively, on the substrate 100. However, the concept of the present invention is not limited thereto, and the sacrificial layers 110 and the semiconductor layers 120 may be stacked at more or less than four levels and three levels, respectively.

In example embodiments, the mold layer may be formed by an epitaxial growth process using an upper surface of the substrate 100 as a seed.

In an example embodiment, the semiconductor layers 120 may include, e.g., silicon, and the sacrificial layers 110 may include a material having a selectivity with respect to the semiconductor layers 120, e.g., silicon-germanium.

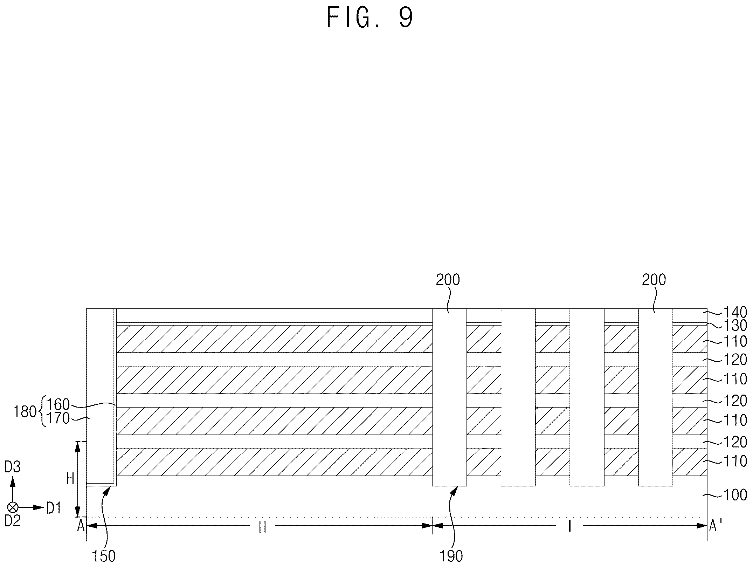

Referring to FIGS. 8 and 9, an insulation pad layer 130 and a first mask layer 140 may be sequentially stacked in the third direction D3 on the mold layer, a dry etching process may be performed on the first mask layer 140, the insulation pad layer 130 and the mold layer to form a first opening 150 exposing the upper surface of the substrate 100, and a first division structure 180 may be formed in the first opening 150.

The insulation pad layer 130 may include an oxide, e.g., silicon oxide, and the first mask layer 140 may include an insulating nitride, e.g., silicon nitride.

In example embodiments, the first division structure 180 may have a lattice shape in a plan view, and thus a plurality of memory block regions each of which may have, e.g., a rectangular shape may be defined in each of the first and second directions D1 and D2 on the memory cell region of the substrate 100. However, the inventive concept is not limited thereto, and each of the memory block regions may have other shapes in a plan view. FIGS. 8 and 9 shows a portion of the first division structure 180.

In example embodiments, each of the memory block regions may include first and second regions I and II arranged in the first direction D1.

In an example embodiment, the first division structure 180 may include a first division pattern 160 on a sidewall and a bottom of the first opening 150 and a second division pattern 170 filling the remaining portion of the first opening 150. A sidewall and a lower surface of the second division pattern 170 may be covered by the first division pattern 160. The first division pattern 160 may include an insulating nitride, e.g., silicon nitride, and the second division pattern 170 may include an oxide, e.g., silicon oxide.

For example, a dry etching process may be performed on the first mask layer 140, the insulation pad layer 130 and the mold layer to form second openings 190 exposing the upper surface of the substrate 100, and third division patterns 200 may be respectively formed in the second openings 190.

In example embodiments, the third division patterns 200 may respectively have a bar shape extending in the second direction D2 in a plan view, and may be spaced apart from each other in each of the first and second directions D1 and D2. The third division patterns 200 may include an oxide, e.g., silicon oxide.

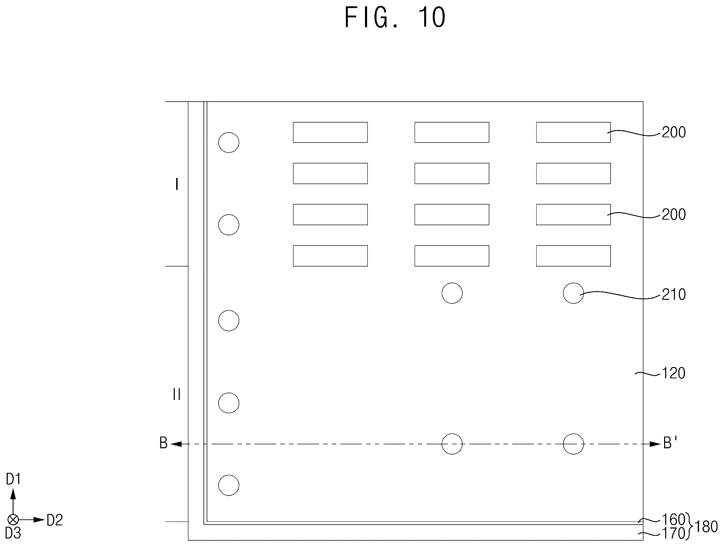

Referring to FIGS. 10 and 11, a dry etching process may be performed on the first mask layer 140, the insulation pad layer 130 and the mold layer to form third openings exposing the upper surface of the substrate 100, and support patterns 210 may be respectively formed in the third openings.

In example embodiments, the support patterns 210 may have a shape of, e.g., a circle, an ellipse, a polygon, a polygon with rounded corners, etc., in a plan view, and may be spaced apart from each other in each of the first and second directions D1 and D2. The support patterns 210 may include an insulating nitride, e.g., silicon nitride.

A first insulating interlayer 220 may be formed on the first mask layer 140, the first division structure 180, the third division patterns 200 and the support patterns 210. The first insulating interlayer 220 may include an oxide, e.g., silicon oxide.

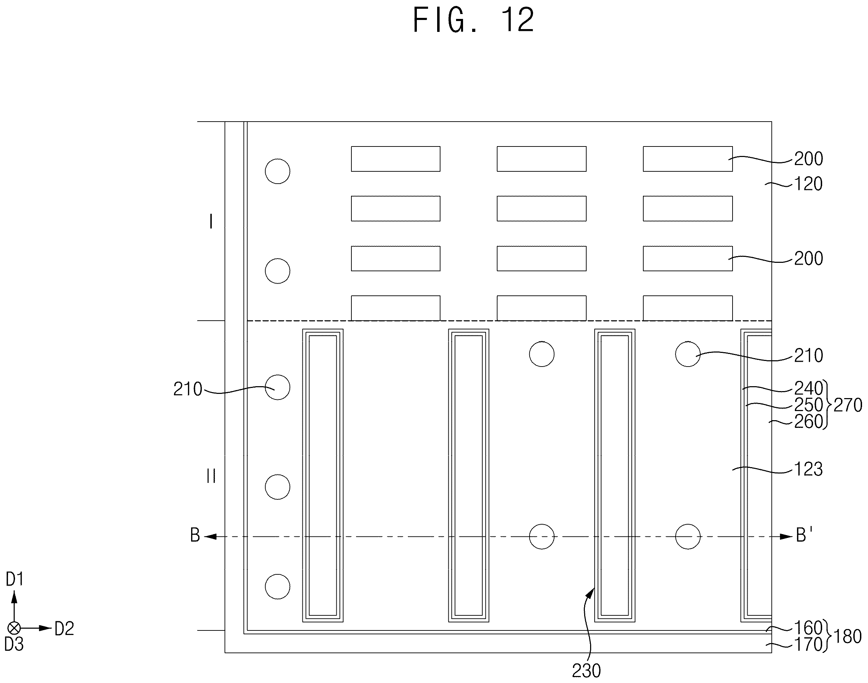

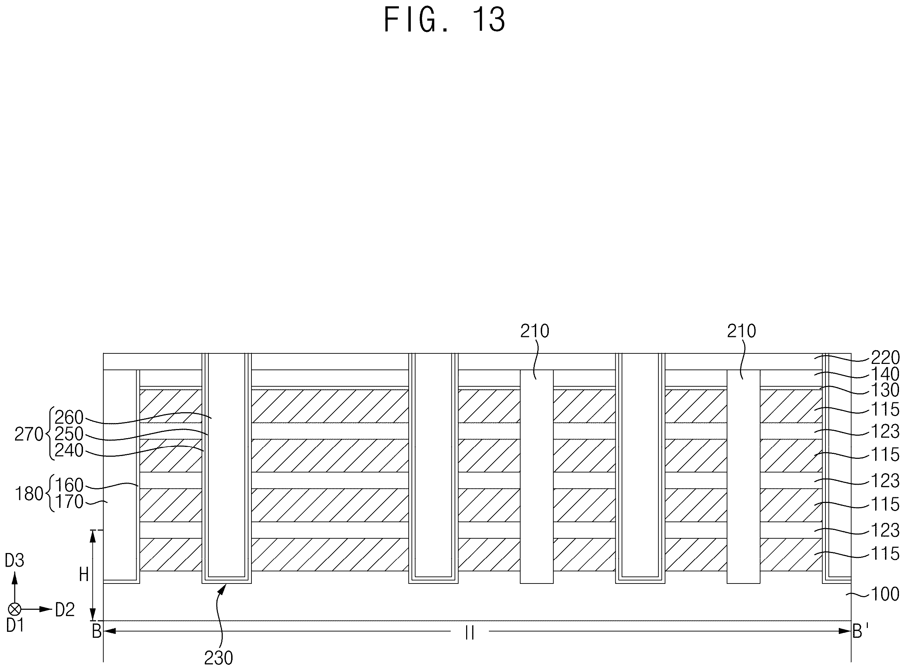

Referring to FIGS. 12 and 13, a dry etching process may be performed on the first insulating interlayer 220, the first mask layer 140, the insulation pad layer 130 and the mold layer to form fourth openings 230 exposing the upper surface of the substrate 100, and second division structures 270 may be respectively formed in the fourth openings 230.

In example embodiments, the second division structures 270 may have a bar shape extending in the first direction D1 in a plan view, and may be spaced apart from each other in the second direction D2. In example embodiments, each of the second division structures 270 may overlap in the first direction D1 a portion of the mold layer between neighboring ones of the third division patterns 200 in the second direction D2.

In an example embodiment, a second division structure 270 may include fourth to sixth division patterns 240, 250 and 260 sequentially stacked from a sidewall and a bottom of a fourth opening 230. Each of the fourth and sixth division patterns 240 and 260 may include an oxide, e.g., silicon oxide, and the fifth division pattern 250 may include an insulating nitride, e.g., silicon nitride.

As the second division structures 270 are formed, portions of the sacrificial layers 110 and the semiconductor layers 120 included in a portion of the mold layer on the second region II may be transformed into first sacrificial patterns 115 and semiconductor patterns 123, respectively.

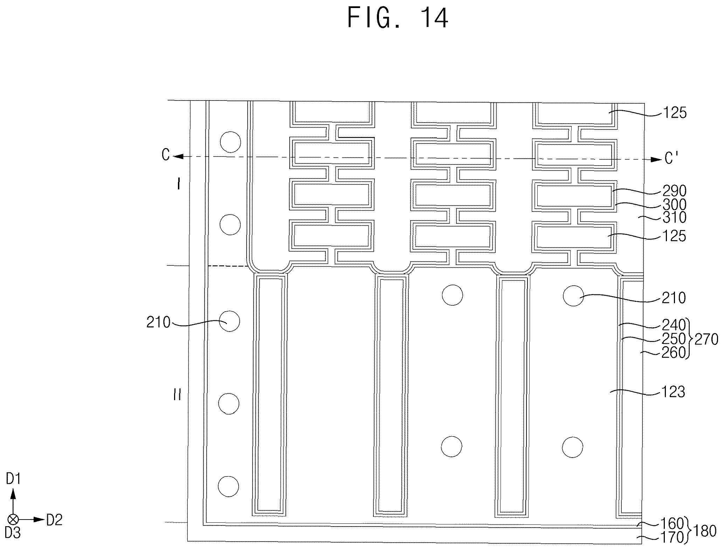

Referring to FIGS. 14 and 15, a dry etching process may be performed on the first insulating interlayer 220, the first mask layer 140, the insulation pad layer 130 and the mold layer to form fifth openings 280 exposing the upper surface of the substrate 100.

In example embodiments, the fifth openings 280 may respectively extend in the first direction D1 between neighboring ones of the third division patterns 200 in the second direction D2, and may be spaced apart from each other in the second direction D2 in the first region I. Each of the fifth openings 280 may be aligned with a corresponding second division structure 270 in the first direction D1, and may extend through a portion of the fourth division pattern 240 at an end portion in the first direction D1 of the second division structure 270 to expose a sidewall of the fifth division pattern 250.

As the fifth openings 280 are formed, portions of the sacrificial layers 110 and the semiconductor layers 120 between neighboring ones of the third division patterns 200 in the first direction D1 and between the fifth openings 280 on the memory cell region of the substrate 100 may be transformed into second sacrificial patterns and channels 125, respectively, and portions of the insulation pad layer 130 and the first mask layer 140 on an uppermost second sacrificial pattern may remain as an insulation pad and a first mask 145.

A wet etching process may be performed through the fifth openings 280 to remove portions of the second sacrificial patterns in the first region I, and most portions of the third division patterns 200 adjacent to the fifth openings 280 and the insulation pad on the first region I may also be removed.

Thus, first gaps may be formed between neighboring ones of the channels 125 in the third direction D3, between an uppermost channel 125 and the first mask 145, and between a lowermost channel 125 and the upper surface of the substrate 100. Additionally, the first gaps may be enlarged in the first direction D1, so that portions of the third division patterns 200 respectively at the same level as the channels 125 may remain and other portions of the third division patterns 200 may be removed.

First and second insulation layers may be sequentially stacked on inner walls of the first gaps, sidewalls and bottoms of the fifth openings 280 and the first insulating interlayer 220, a seventh division layer may be formed on the second insulation layer to fill the first gaps and the fifth openings 280, and a planarization process may be performed on the seventh division layer, the first and second insulation layers, the first insulating interlayer 220, and the second division structures 270 until an upper surface of the first mask 145 is exposed. Thus, a third division structure including first and second insulation patterns 290 and 300 and a seventh division pattern 310 may be formed in the first gaps and the fifth openings 280, and the first insulating interlayer 220 may be removed.

The first insulation pattern 290 and the seventh division pattern 310 may include an oxide, e.g., silicon oxide, and the second insulation pattern 300 may include an insulating nitride, e.g., silicon nitride. Portions of the third division patterns 200 remaining between the channels 125 may be merged with the first insulation pattern 290, and hereinafter, the merged structure may be referred to as a first insulation pattern 290. In some example embodiments, the first insulation pattern 290 and a portion of the fourth division pattern 240 exposed by the fifth opening 280 may contact each other to be merged with each other.

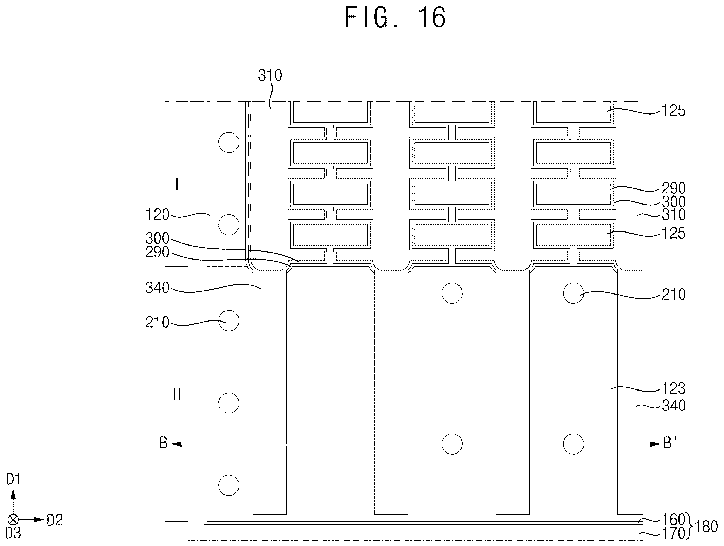

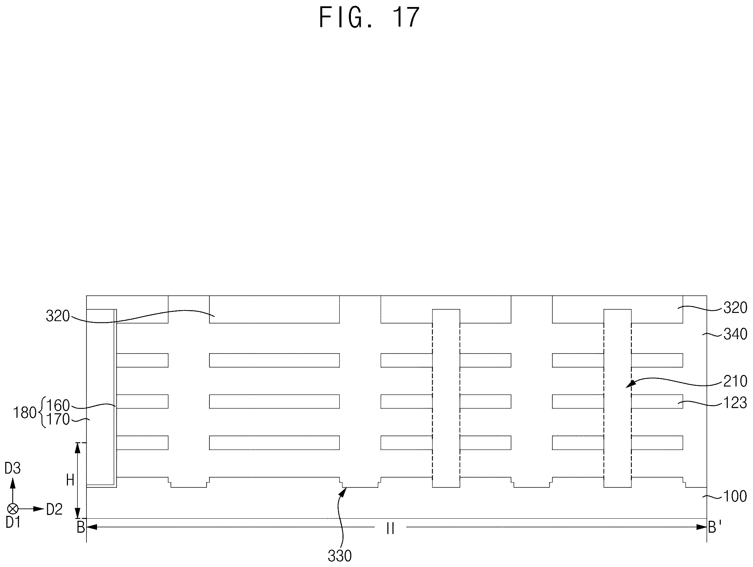

Referring to FIGS. 16 and 17, a second mask 320 may be formed on the first mask layer 140, the first mask 145, the second division structures 270, and the third division structure, and a dry etching process may be performed using the second mask 320 as an etching mask to remove the second division structures 270 so that sixth openings 330 exposing the upper surface of the substrate 100 may be reopened. Portions of the first sacrificial patterns 115 adjacent to the sixth openings 330 may be removed through the sixth openings 330, and the insulation pad layer 130 may also be removed.

Thus, second gaps may be formed between ones of the semiconductor patterns 123 neighboring in the third direction D3, between an uppermost semiconductor pattern 123 and the first mask layer, and between a lowermost semiconductor pattern 123 and the substrate 100.

The second mask 320 may include an insulating nitride, e.g., silicon nitride, and the first mask layer 140 and the first mask 145 may be merged to the second mask 320. Hereinafter, the merged structure including the first mask layer 140, the first mask 145 and the second mask 320 may be referred to as the second mask 320.

An eighth division layer may be formed on the substrate 100 and the second mask 320 to fill the second gaps and the sixth openings 330, and a planarization process may be performed on the eighth division layer until an upper surface of the second mask 320 is exposed to form an eighth division pattern 340 in the second gaps and the sixth openings 330. The eighth division pattern 340 may include an insulating nitride, e.g., silicon nitride, and thus, in some example embodiments, the support patterns 210 may be merged to the eighth division pattern 340.

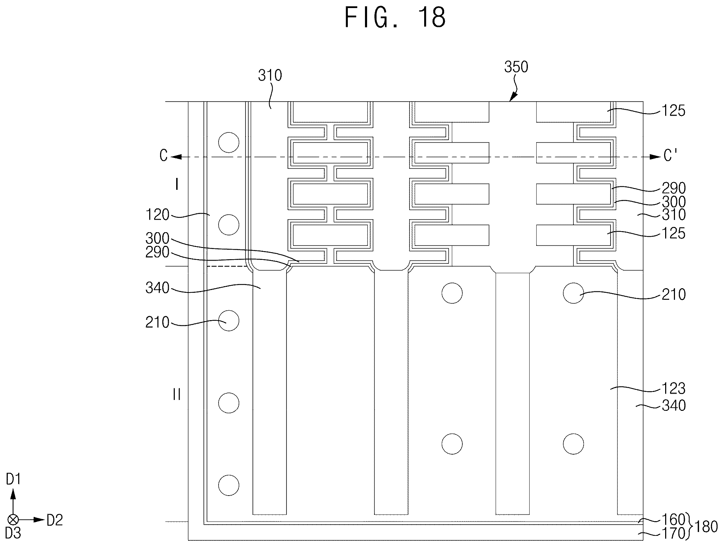

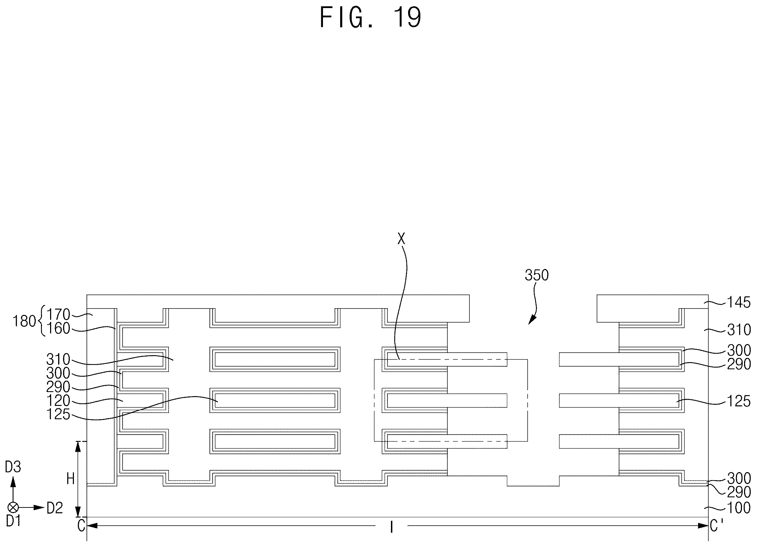

Referring to FIGS. 18 and 19, the second mask 320 and the third division structure may be partially removed by, e.g., a dry etching process to form a seventh opening 350 exposing the upper surface of the substrate 100.

Subsequently, through the seventh opening 350, by performing a wet etching process, for example, a portion of the third division structure formed between the channels 125 neighboring each other in the third direction D3 may be removed to form fourth gaps. Accordingly, first end portions in the second direction D2 of the channels 125 and sidewalls in the second direction D2 of the third division structure may be exposed.

In example embodiments, through the seventh opening 350 and the fourth gaps, the upper surface of substrate 100, upper and lower surfaces and sidewalls in the second direction D2 of the first end portions of the channels 125, and the sidewalls in the second direction D2 of the third division structure may be exposed.

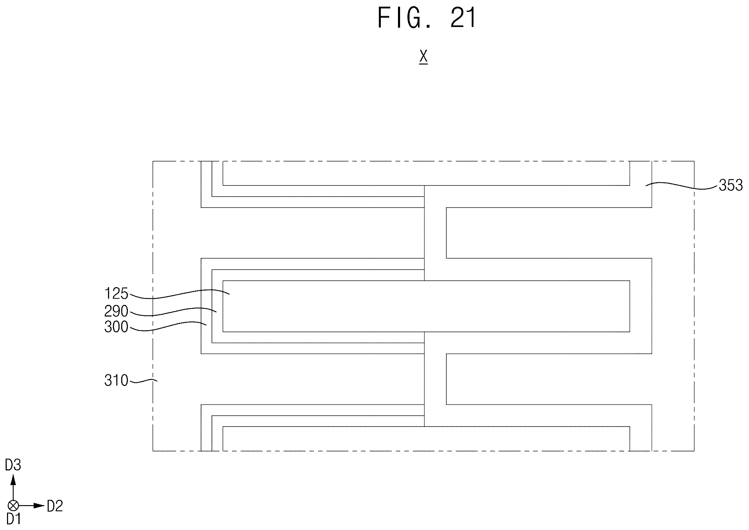

Referring to FIG. 21, an etch stop layer 353 may be formed on the exposed upper surface of substrate 100, the upper and lower surfaces and the sidewalls in the second direction D2 of the first end portions of the channels 125, and the sidewalls in the second direction D2 of the third division structure exposed by the seventh opening 350 and the fourth gaps, and a sidewall and the upper surface of first mask 145.

The etch stop layer 353 may include a high-k metal oxide, for example, hafnium oxide (HfO₂), zirconium oxide (ZrO₂), hafnium zirconium oxide (HfZrO), aluminum oxide (Al₂O₃), etc.

If the etch stop layer 353 is a silicon nitride layer or a silicon carbonitride layer, nitrogen atoms or carbon atoms may diffuse into the channels 125, which could deteriorate the electrical characteristics of the channels 125. However, in the method of manufacturing the semiconductor device according to example embodiments, the etch stop layer 353 may be formed to include a metal oxide, and thus, deterioration of the electrical characteristics of the channels 125 may be prevented or suppressed.

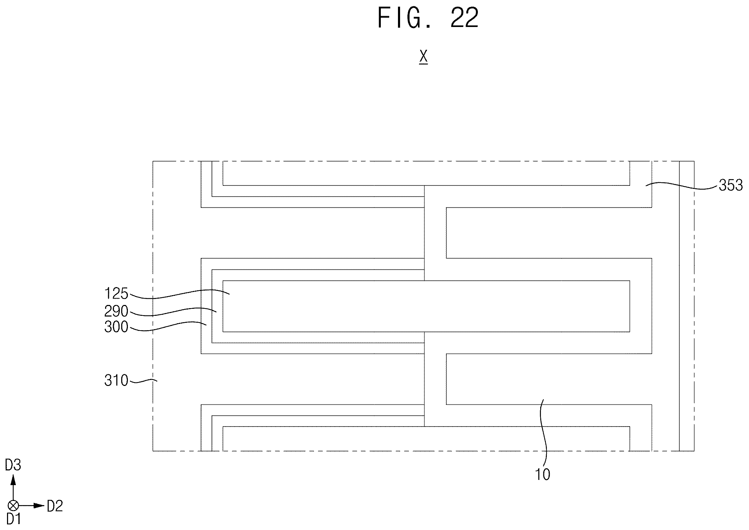

Referring to FIG. 22, a first sacrificial mold layer 10 may be formed on an inner wall of the etch stop layer 353. The first sacrificial mold layer 10 may be formed to fill the fourth gaps. The first sacrificial mold layer 10 may include an oxide, for example, silicon oxide.

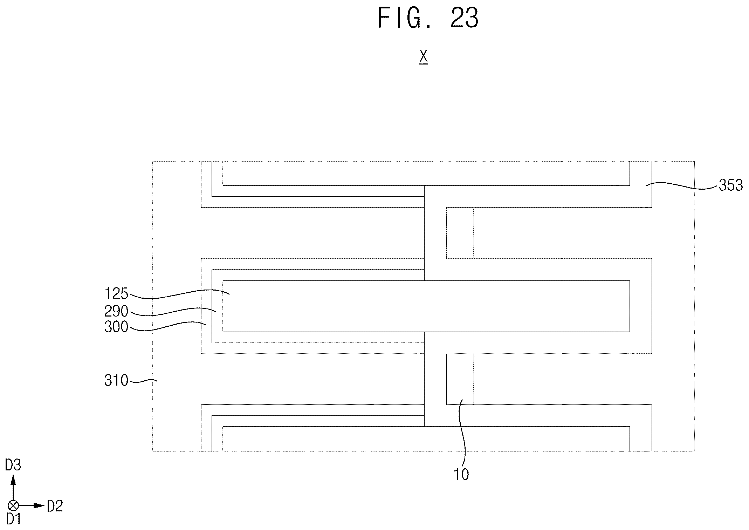

Referring to FIG. 23, a wet etching process may be performed on the first sacrificial mold layer 10. Accordingly, the first sacrificial mold layer 10 may remain within the fourth gaps on a portion of the inner wall of the etch stop layer 353 that is disposed on the sidewalls of the third division structure.

In addition, the etch stop layer 353 may have strong resistance to the wet etching process. Accordingly, the etch stop layer 353 may not be damaged during the wet etching process for the first sacrificial mold layer 10.

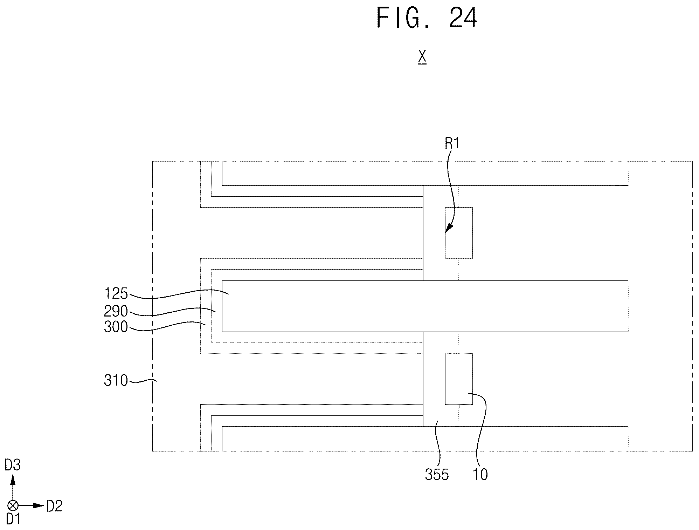

Referring to FIG. 24, an isotropic dry-cleaning process may be performed on the etch stop layer 353. Accordingly, the etch stop layer 353 may be transformed into etch stop patterns 355 formed on the sidewalls of the third division structure. The isotropic dry-cleaning process may include, for example, a plasma etching process.

In addition, during the isotropic dry-cleaning process, the etch stop layer 353 may have a high etching selectivity with respect to silicon, silicon nitride, and silicon oxide. Accordingly, surrounding structures such as the substrate 100, the channels 125, the first mask 145, etc., may not be damaged during the dry-cleaning process.

In example embodiments, first recesses R1 may be respectively formed on first sidewalls in the second direction D2 of the etch stop patterns 355 that contact the first sacrificial mold layer 10.

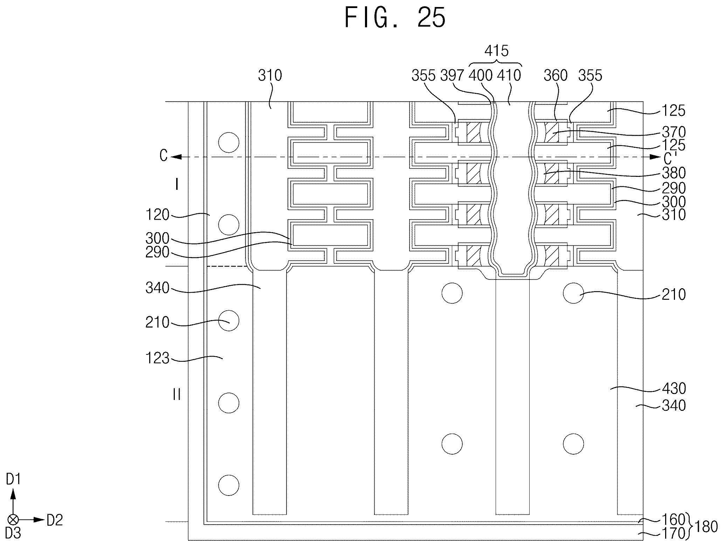

Referring to FIGS. 25 to 27, the first sacrificial mold layer 10 may be removed by, for example, a wet etching process.

The etch stop patterns 355 may have strong resistance to the wet etching process. Accordingly, the etch stop patterns 355 may not be damaged during the wet etching process for the first sacrificial mold layer 10.

Subsequently, gate insulation patterns 360 may be formed on the exposed upper surface of substrate 100 and the upper and lower surfaces and the sidewalls of the first end portions of the channels 125 exposed by the seventh opening 350 and the fourth gaps by performing, for example, a thermal oxidation process.

Subsequently, a first burial layer may be formed on the first sidewalls of the etch stop patterns 355 and surfaces of the gate insulation patterns 360, and first burial patterns 391 may be formed on the first sidewalls of the etch stop patterns 355 by a wet etching process performed thereon. The first burial patterns 391 may include an oxide, for example, silicon oxide.

Subsequently, a gate electrode layer may be formed on the first burial patterns 391 and the gate insulation patterns 360, and gate electrodes 370 partially surrounding the gate insulation patterns 360 may be formed by performing a wet etching process or a dry etching process thereon.

Subsequently, a gate mask layer may be formed on the first burial patterns 391, the gate electrodes 370, and the gate insulation patterns 360, and gate masks 380 respectively contacting sidewalls in the second direction D2 of the gate electrodes 370 and partially surrounding the gate insulation patterns 360 may be formed by performing a wet etching process or dry etching process thereon.

The gate electrodes 370, the gate insulation patterns 360, and the gate masks 380 may together form gate structures on the memory cell region of substrate 100, and each of the gate structures may extend in the first direction D1 while surrounding the first end portions of the channels 125 in first region I of the substrate 100. Accordingly, the gate structures may be formed to be spaced apart from each other in the third direction D3 at opposite sides in the second direction D2 of the seventh opening 350. The gate structures may serve as word lines of the semiconductor device.

Subsequently, second burial patterns 393 filling spaces between the gate structures spaced apart in the third direction D3 may be formed, a third insulation layer and a fourth insulation layer may be sequentially stacked on sidewalls in the second direction D2 of the gate structures adjacent to the seventh opening 350, sidewalls in the second direction D2 of the second burial patterns 393, and a bottom of the seventh opening 350, and a ninth division layer filling the remaining portion of the seventh opening 350 may be formed. Subsequently, the third and fourth insulation layers and the ninth separation layer may be planarized until the upper surface of second mask 320 is exposed to respectively form a third insulation pattern 395, a fourth insulation pattern 400, and a ninth division pattern 410.

The second burial patterns 393, the third insulation pattern 395, and the ninth division pattern 410 may include an oxide, for example, silicon oxide, and the fourth insulation pattern 400 may include an insulating nitride, for example, silicon nitride.

The first and second burial patterns 391 and 393 and the third insulation pattern 395 may be merged with each other, and hereinafter, may be collectively referred to as a fourth division structure 397 and may form an isolation pattern and be formed of insulating material only. The fourth insulation pattern 400 and the ninth division pattern 410 may together form a fifth division structure 415.

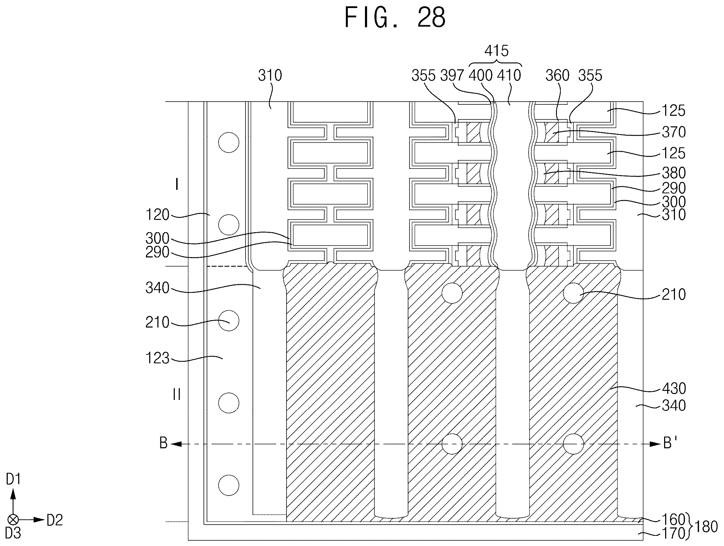

Referring to FIGS. 28 and 29, the eighth division pattern 340 may be removed by, e.g., a dry etching process to form eighth openings 420 exposing the upper surface of the substrate 100, and e.g., a wet etching process may be performed through the eighth openings 420 to remove the semiconductor patterns 123 to form third gaps, a conductive pad layer may be formed to fill the third gaps, and, for example, a wet etching process may be performed on the conductive pad layer to form conductive pads 430 respectively in the third gaps.

In example embodiments, the conductive pads 430 may respectively extend in the first direction D1 in the second region II, and may be spaced apart from each other in the second direction D2. Additionally, the conductive pads 430 may be spaced apart from each other in the third direction D3.

A tenth division layer may be formed to fill the eighth openings 420, and a planarization process may be performed on the tenth division layer until the upper surface of the second mask 320 is exposed to form tenth division patterns in the eighth openings 420, respectively. The tenth division pattern may include an insulating nitride, e.g., silicon nitride, and may contact portions of the eighth division pattern 340 between the conductive pads 430 spaced apart from each other in the third direction D3 to be merged thereto. Hereinafter, the eighth division pattern 340 together with the tenth division pattern merged thereto may be referred to as the eighth division pattern 340.

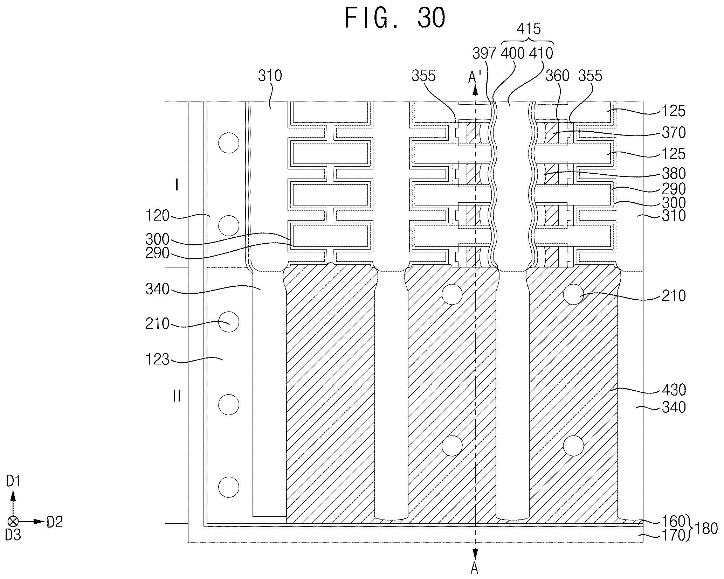

Referring to FIGS. 30 and 31, the second mask 320, the eighth division pattern 340 and the conductive pads 430 in the second region II may be partially removed by, e.g., a dry etching process to form a ninth opening exposing an upper surface of the eighth division pattern 340.

In example embodiments, after the dry etching process, each of the conductive pads 430 and a portion of the eighth division pattern 340 thereon may collectively form a step layer extending in the first direction D1, and a stack structure including the conductive pads 430 and the eighth division pattern 340 may have a staircase structure having a length decreasing from a bottom toward a top thereof in a stepwise manner. During the dry etching process, upper portions of the first and second division patterns 160 and 170 contacting an end portion in the first direction D1 of the conductive pad 430 may also be removed.

A second insulating interlayer 435 may be formed to fill the ninth opening. The second insulating interlayer 435 may include an oxide, e.g., silicon oxide, and in some example embodiments, may be merged to the second division pattern 170.

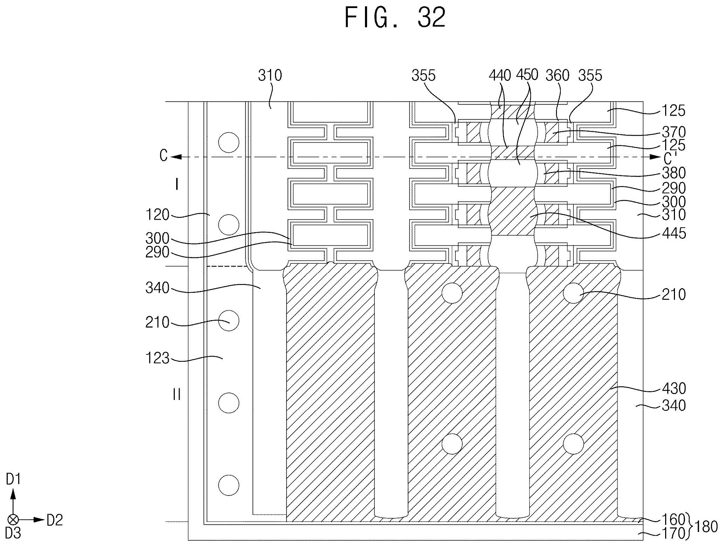

Referring to FIGS. 32 to 34, first trenches may be formed by partially removing the fifth division structure 415 and the third insulation pattern 395 of the fourth division structure 397 by, for example, a dry etching process on the memory cell region of substrate 100, and bit lines 440 may be formed by forming a bit line layer within the first trenches and patterning the bit line layer.

As the first trench is formed, the first end portions of the channels 125, the gate insulation patterns 360, and the gate masks 380 arranged in the third direction D3 on opposite sides in the second direction D2 of the fifth division structure 415 may be exposed. Accordingly, the bit lines 440 may contact the first end portions of the channels 125, the gate insulation patterns 360, and the gate masks 380 exposed by the first trench.

In example embodiments, the bit lines 440 may be formed to be spaced apart from each other in the first direction D1 in first region I, and the bit lines 440 may respectively contact and be electrically connected to the channels 125 arranged in the first direction D1. However, among the bit lines 440 arranged in the first direction D1, a bit line adjacent to second region II may be a dummy bit line 445.

In an example embodiment, the bit lines 440 may include polysilicon doped with n-type impurities. In another example embodiment, the bit lines 440 may include a metal, a metal nitride, silicide, etc.

Subsequently, eleventh division patterns 450 may be respectively formed between the bit lines 440 arranged in the first direction D1 on the memory cell region of substrate 100. The eleventh division patterns 450 may include an oxide, for example, silicon oxide.

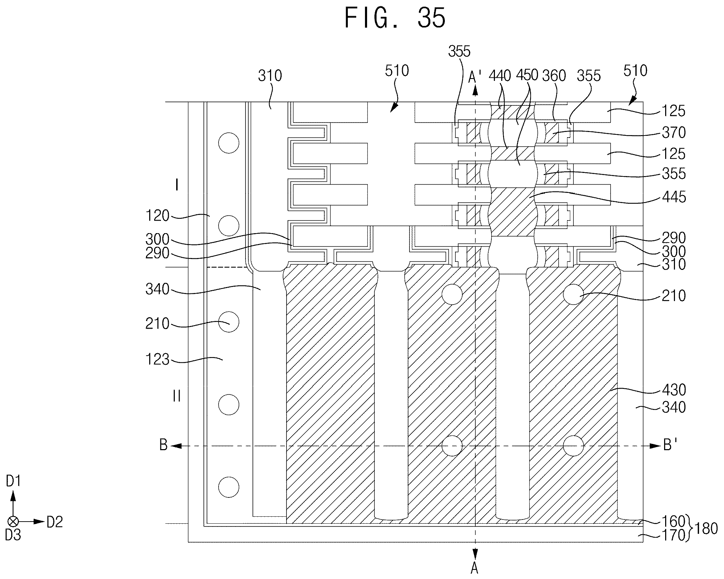

Referring to FIGS. 35 to 38, a capping layer 500 may be formed on the eleventh division patterns 450, the bit lines 440, the dummy bit line 445, the second interlayer insulating layer 435, the second mask 320, the seventh division pattern 310, the fifth division structure 415 and the eleventh division patterns 450. The capping layer 500 may include an insulating nitride, for example, silicon nitride.

Subsequently, eleventh openings 510 exposing the upper surface of substrate 100 may be formed by partially removing the capping layer 500, the second mask 320, and the third division structure by, for example, a dry etching process.

Subsequently, fifth gaps may be formed by removing portions of the third division structure respectively formed between the channels 125 neighboring each other in the third direction D3 by, for example, a wet etching process through the eleventh openings 510. Accordingly, upper and lower surfaces and sidewalls of second end portions in the second direction D2 of the channels 125, and second sidewalls in the second direction D2 of etch stop patterns 355 may be exposed by the eleventh openings 510 and the fifth gaps.

In the wet etching process, the etch stop patterns 355 may serve as an etch stop line.

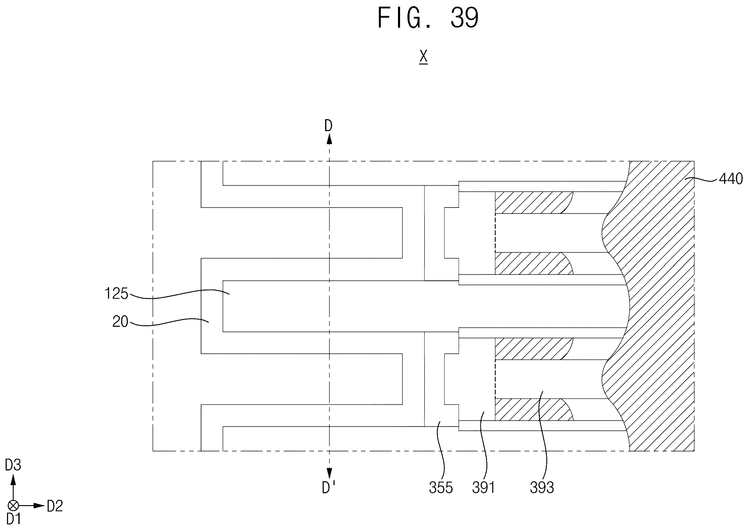

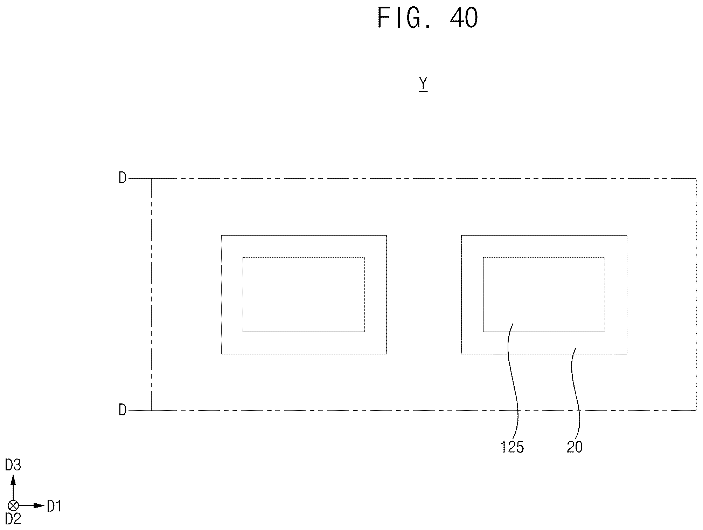

Referring to FIGS. 39 and 40, a second sacrificial mold layer 20 may be formed on the exposed upper surface of substrate 100, the upper and lower surfaces and the sidewalls of the second end portions of the channels 125, the second sidewalls of etch stop patterns 355, the sidewall of the second mask 320, and the sidewall and the upper surface of the capping layer 500. The second sacrificial mold layer 20 may include an oxide, for example, silicon oxide.

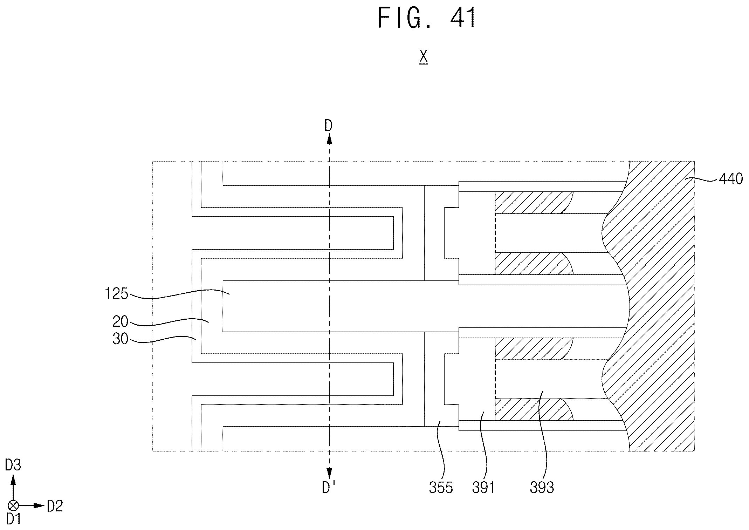

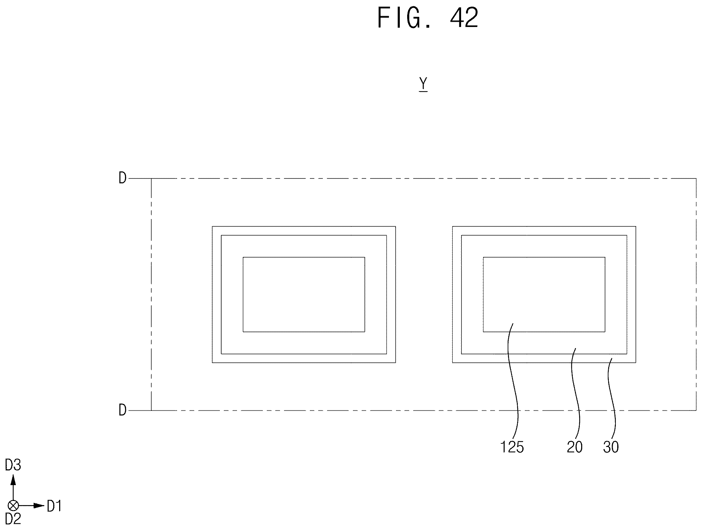

Referring to FIGS. 41 and 42, a third sacrificial mold layer 30 may be formed on an inner wall of the second sacrificial mold layer 20. The third sacrificial mold layer 30 may include a nitride, for example, silicon nitride.

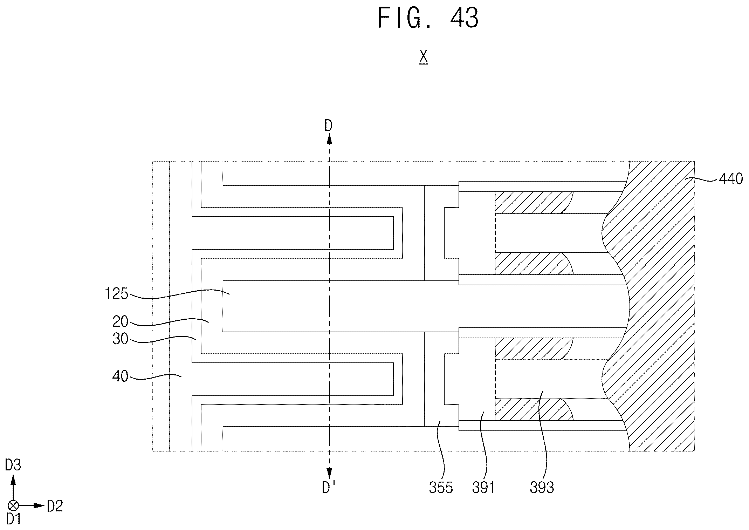

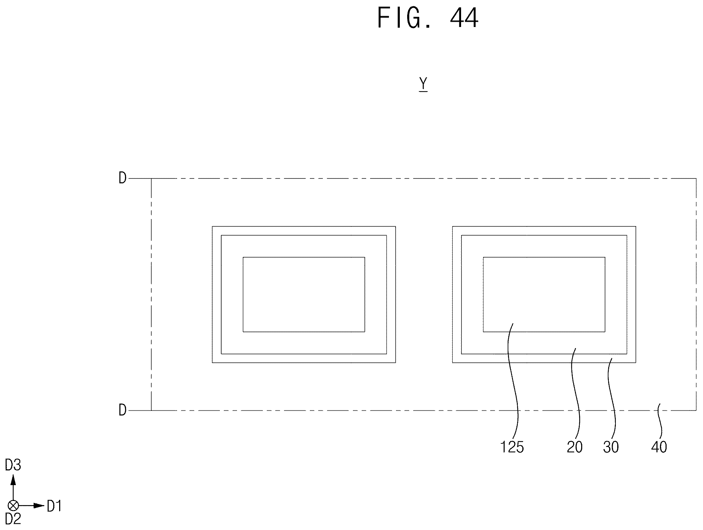

Referring to FIGS. 43 and 44, a fourth sacrificial mold layer 40 may be formed on an inner wall of third sacrificial mold layer 30. The fourth sacrificial mold layer 40 may be formed to fill remaining portions of the fifth gaps. The fourth sacrificial mold layer 40 may include an oxide, for example, silicon oxide.

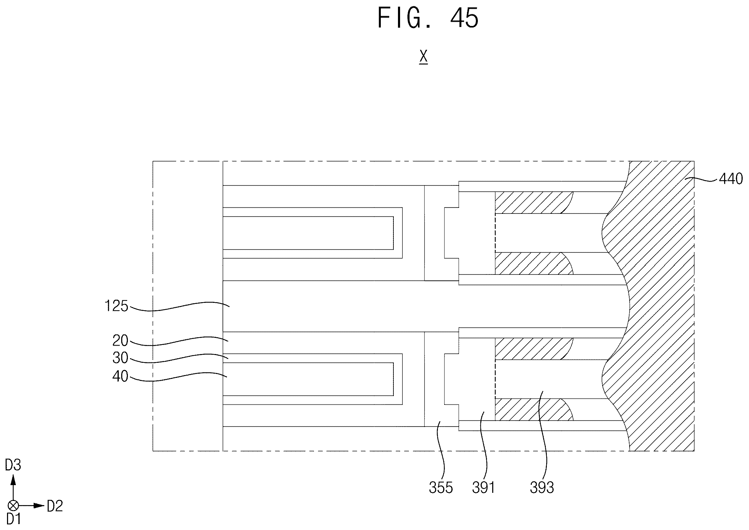

Referring to FIG. 45, portions of the second to fourth sacrificial mold layers 20, 30 and 40 except for portions of the second to fourth sacrificial mold layers 20, 30 and 40 formed within the fifth gaps may be removed.

Accordingly, the second to fourth sacrificial mold layers 20, 30 and 40 may be divided into a plurality of second sacrificial mold layers 20, a plurality of third sacrificial mold layers 30, and a plurality of fourth sacrificial mold layers 40, respectively.

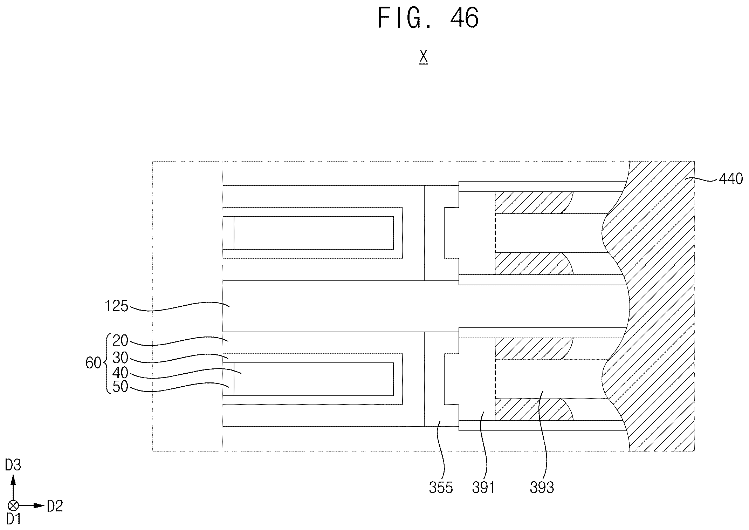

Referring to FIG. 46, a second recess may be formed by partially removing the fourth sacrificial mold layer 40 through the eleventh openings 510. Subsequently, the fifth sacrificial mold layer 50 filling the second recess may be formed. The fifth sacrificial mold layer 50 may include a nitride, for example, silicon nitride. Accordingly, the third and fifth sacrificial mold layers 30 and 50 may be merged with each other.

In example embodiments, the third and fifth sacrificial mold layers 30 and 50 may be formed to surround the fourth sacrificial mold layer 40. For example, the fourth sacrificial mold layer 40 may be formed within a space defined by the third sacrificial mold layer 30 and the fifth sacrificial mold layer 50.

The second to fifth sacrificial mold layers 20, 30, 40 and 50 may together form the sacrificial mold layer structures 60. Each of the sacrificial mold layer structures 60 may be formed to fill space between the second end portions of the channels 125 spaced apart from each other in the first and third directions D1 and D3.

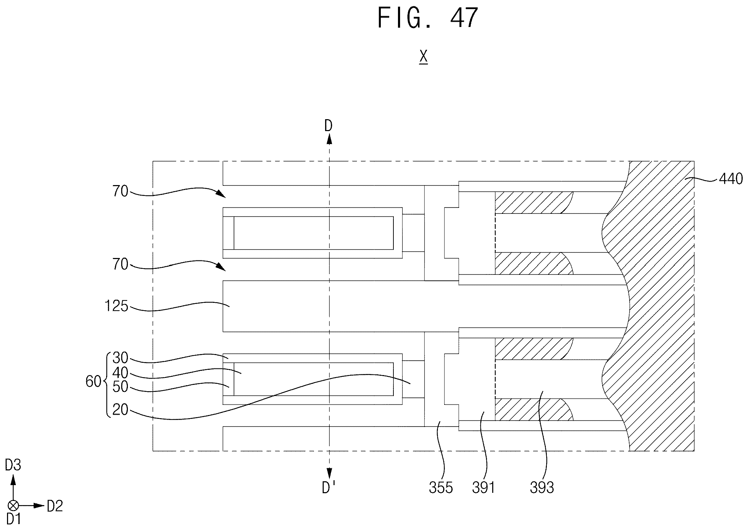

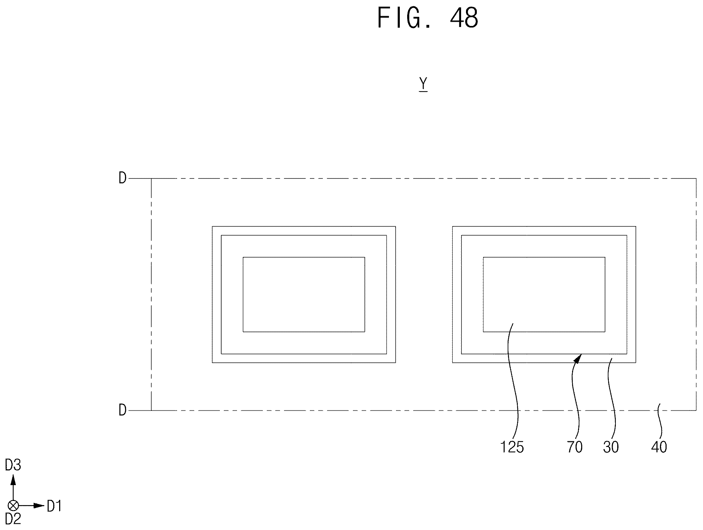

Referring to FIGS. 47 and 48, the second sacrificial mold layer 20 may be partially removed through the eleventh openings 510. Accordingly, the second sacrificial mold layer 20 may remain between the third sacrificial mold layer 30 and the etch stop pattern 355. In example embodiments, the second sacrificial mold layer 20 may be partially removed by, for example, a wet etching process.

As the second sacrificial mold layer 20 is partially removed, sixth gaps 70 may be respectively formed between a sacrificial mold layer structure 60 and the second end portions of the channels 125. The sixth gaps 70 may reopen the upper and lower surfaces and the sidewalls of the second end portions of the channels 125 and the second sidewalls of etch stop patterns 355.

In example embodiments, a cross-section of each of the sixth gaps 70 in a plane extending in the first and third directions D1 and D3 may have, for example, a rectangular ring shape.

During the wet etching process, the etch stop pattern 355 may serve as an etch stop line.

If the etch stop pattern 355 serving as an etch stop line during the wet etching process does not exist, controlling etching amount of the second sacrificial mold layer 20 may be difficult during the wet etching process. Accordingly, if the second sacrificial mold layer 20 supporting the sacrificial mold layer structure 60 are excessively removed, the sacrificial mold layer structure 60 may collapse. Also, if the second sacrificial mold layers 20 are insufficiently etched, capacitance of the capacitor structure may decrease as sufficient space for forming the first capacitor electrodes 520 may not be secured.

However, in the concept of the present invention, the etch stop pattern 355 serving as an etch stop line may be formed between the sacrificial mold layer structure 60 and the fourth division structure 397. Accordingly, the improved control over the etching amount of the second sacrificial mold layer 20 during the wet etching process may prevent both the collapse of the sacrificial mold layer structure 60 and the decrease in capacitance of the capacitor structure.

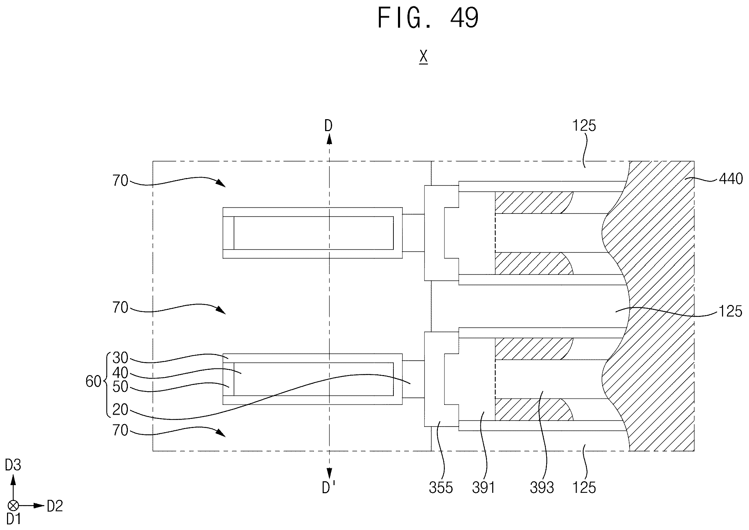

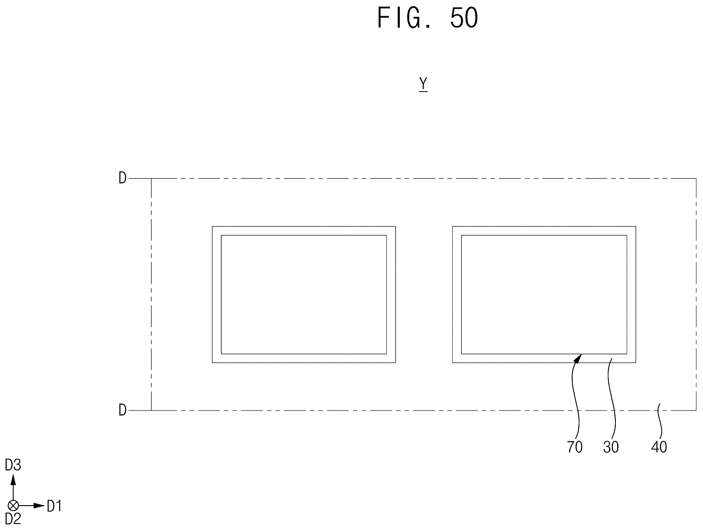

Referring to FIGS. 49 and 50, the second end portions of the channels 125 exposed by the sixth gaps 70 may be partially removed. Accordingly, the sixth gaps 70 may be expanded, and a cross-section of each of the sixth gaps 70 in a plane extending in the first and third directions D1 and D3 may have, for example, a rectangular shape.

In example embodiments, the sacrificial mold layer structure 60 may have a plate shape, and the sixth gaps 70 spaced apart from each other in first and third directions D1 and D3 may extend through the sacrificial mold layer structure 60 having the plate shape.

In example embodiments, the sidewalls of the channels 125 may be formed to be recessed as compared to the second sidewall of the etch stop pattern 355.

After partially removing the second end portions of the channels 125, a cleaning process may be performed. Since the fourth division structure 397 may be covered by the etch stop pattern 355, the fourth division structure 397 may not be damaged during the cleaning process.

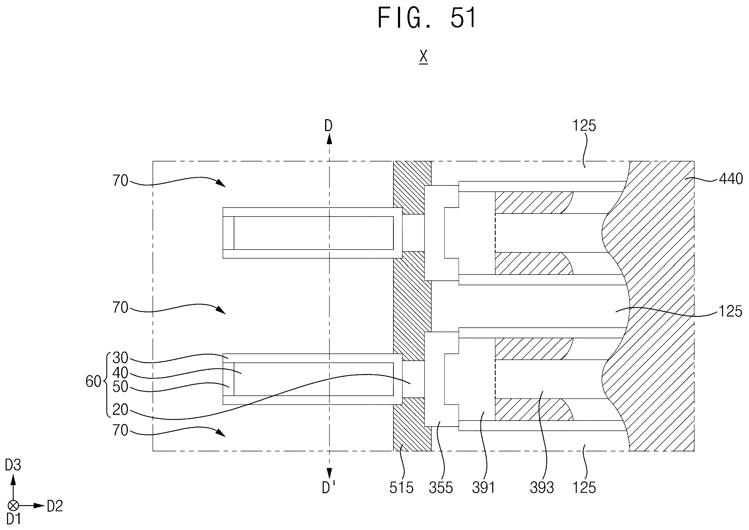

Referring to FIG. 51, ohmic contacts 515 may respectively be formed on sidewalls in the second direction D2 of the second end portions of the channels 135 in the sixth gaps 70.

In example embodiments, the ohmic contacts 515 may be formed by performing, for example, an epitaxial growth process using the sidewalls of channels 135 as seeds. In example embodiments, the ohmic contacts 515 may also be formed by, for example, forming an ohmic contact layer to fill the sixth gaps and partially removing the ohmic contact layer through a wet etching process.

While the drawings illustrate the ohmic contacts 515 covering not only the etch stop patterns 355 but also portions of the second sacrificial mold layer 20 and the third sacrificial mold layer 30, the concept of the present invention is not limited thereto. For example, the ohmic contact 515 may not cover the third sacrificial mold layer 30 or the second sacrificial mold layer 20.

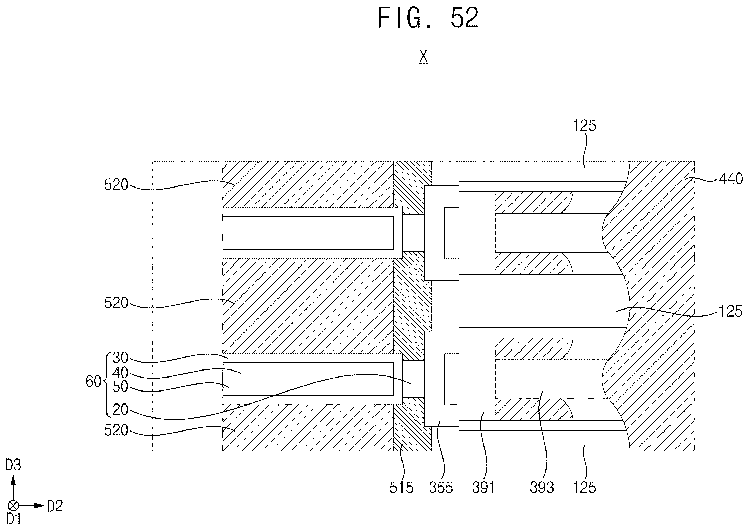

Referring to FIG. 52, the first capacitor electrodes 520 may be respectively formed to fill the sixth gaps 70.

The first capacitor electrodes 520 may be respectively formed in the sixth gaps 70 which are formed by removing the second end portions of the channels 125 and the second sacrificial mold layers 20 covering the second end portions of the channels 125. Accordingly, as compared to when the sixth gaps 70 are formed by removing only the second end portions of the channels 125, the first capacitor electrodes 520 may be formed with greater surface areas.

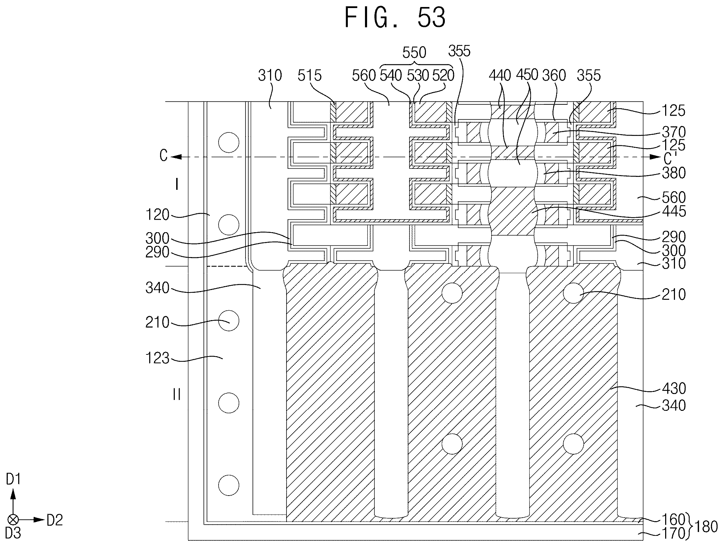

Referring to FIGS. 53 to 55, the sacrificial mold layer structures 60 may be removed. Accordingly, portions of the second sidewalls of etch stop patterns 355, surfaces of the ohmic contacts 515, surfaces of the first capacitor electrodes 520 and the sidewalls of the third division structure may be exposed.

Subsequently, a dielectric layer and a second capacitor electrode layer may be sequentially stacked on the exposed portions of the second sidewalls of the etch stop patterns 355, the surfaces of the ohmic contacts 515, the surfaces of the first capacitor electrodes 520, the sidewalls of the third division structure, a sidewall of the second mask 320, and a sidewall and an upper surface of the capping layer 500. Subsequently, a plate electrode layer may be formed to fill the fifth gaps and the eleventh openings 510 on the second capacitor electrode layer, and the plate electrode layer, the second capacitor electrode layer and the dielectric layer may be planarized until the upper surface of the capping layer 500 is exposed to form dielectric patterns 530, second capacitor electrodes 540 and plate electrodes 560, respectively.

The first and second capacitor electrodes 520 and 540 and the dielectric patterns 530 may together form the capacitors 550, and the capacitors 550 and the plate electrodes 560 may together form capacitor structures together.

Referring back to FIGS. 1 to 6, a third interlayer insulating layer 600 may be formed on the capacitor structures and the capping layer 500. First contact plugs 612 may be formed to respectively contact upper surfaces of the bit lines 440 by extending through the third interlayer insulating layer 600 and the capping layer 500. Second contact plugs 614 may be formed to respectively contact upper surfaces of the capacitor structures by extending through the third interlayer insulating layer 600. Third contact plugs 616 may be formed to respectively contact upper surfaces of the conductive pads 430 by extending through the third interlayer insulating layer 600, the capping layer 500, the second mask 320 and the eighth division pattern 340 or through the third interlayer insulating layer 600, the capping layer 500 and the second interlayer insulating layer 435.

By performing the above processes, the manufacture of the semiconductor device may be completed.

In the method of manufacturing the semiconductor device, the fourth gaps may be formed by removing the first portions of the third division structure formed between the first end portions of the channels 125, and the gate structures may be formed within the fourth gaps. Subsequently, the fifth gaps may be formed by removing the second portions of the third division structure formed between the second end portions of the channels 125, and the sacrificial mold layer structures 60 including the second sacrificial mold layers 20 covering surfaces of the second end portions of the channels 125 and the third and fourth sacrificial mold layers 30 and 40 sequentially stacked on the second sacrificial mold layers 20 may be formed in the fifth gaps. Subsequently, the sixth gaps 70 may be formed by removing the second sacrificial mold layers 20 and the second end portions of the channels 125, and the first capacitor electrodes 520 may be formed within the sixth gaps 70.

In addition, in the method of manufacturing the semiconductor device, after removing the first portions of the third division structure, the etch stop patterns 355 may be formed on the sidewalls of the second portions of the third division structure.

As compared to when the etch stop patterns 355 are not formed, it may be difficult to control the etching amount of the second sacrificial mold layers 20 in the process of removing the second sacrificial mold layers 20 to form the sixth gaps 70. However, as described above, in the method of manufacturing the semiconductor device, as the etch stop patterns 355 having strong resistance to wet etching processes are formed between the sacrificial mold layer structures 60 and the fourth division structure 397, control of the etching amount of the second sacrificial mold layers 20 may be relatively easy. Accordingly, the improved control over the etching amount of the second sacrificial mold layers 20 during the wet etching process may prevent both the collapse of the sacrificial mold layer structures 60 and the decrease in capacitance of the capacitor structures.

Additionally, when the etch stop patterns 355 are not formed, an increased aspect ratio of the semiconductor device results in greater differences in the etching amounts between upper and lower portions of the second portions of the third division structure, which may impede uniform formation of spaces for the first capacitor electrodes 520. However, in the present method of manufacturing the semiconductor device, the etch stop patterns 355 may serve an etch stop line during the process of removing the second portions of the third division structure, thereby ensuring uniform spaces for the first capacitor electrodes 520 throughout the upper and lower portions of the semiconductor device.

Also, during the cleaning process performed after removing portions of the second end portions of the channels 125, the fourth division structure 397 may be protected by the etch stop pattern 355.

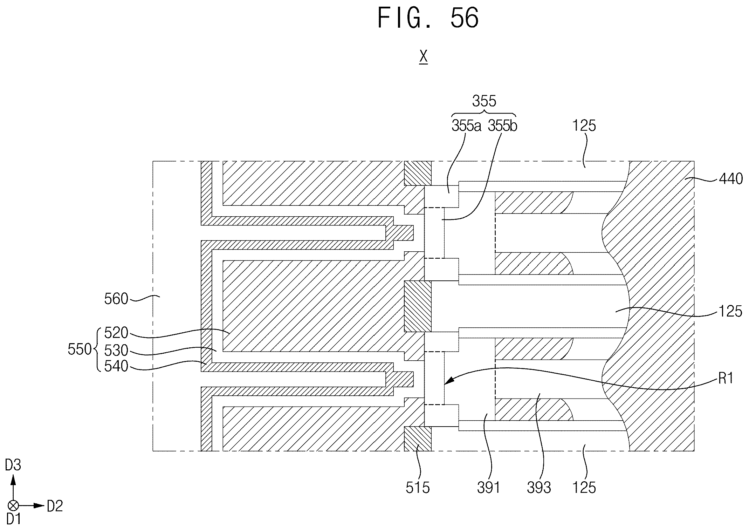

FIG. 56 is a vertical cross-sectional view illustrating a semiconductor device according to example embodiments, corresponding to FIG. 5. The semiconductor device is substantially the same as or similar to those described with reference to FIGS. 1 to 6 except for the shape of the ohmic contacts 515 and the shape of the first capacitor electrodes 520, and thus, repeated explanations are omitted herein.

Referring to FIG. 56, an area of the ohmic contact 515 in a cross-section extending in the first and third directions D1 and D3 may be substantially the same to the maximum cross-sectional area of the channel 125 in the cross-section extending in the first and third directions D1 and D3.

In example embodiments, the first capacitor electrode 520 may cover upper and lower surfaces and a sidewall of the ohmic contact 515 and the second sidewall of etch stop pattern 355.

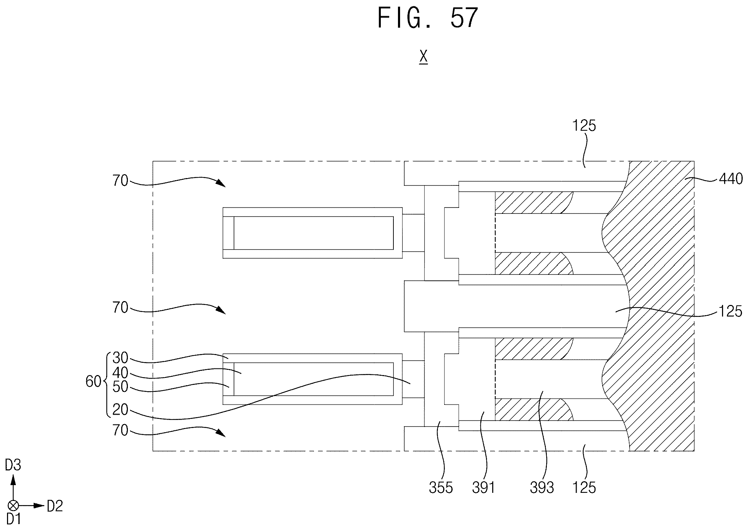

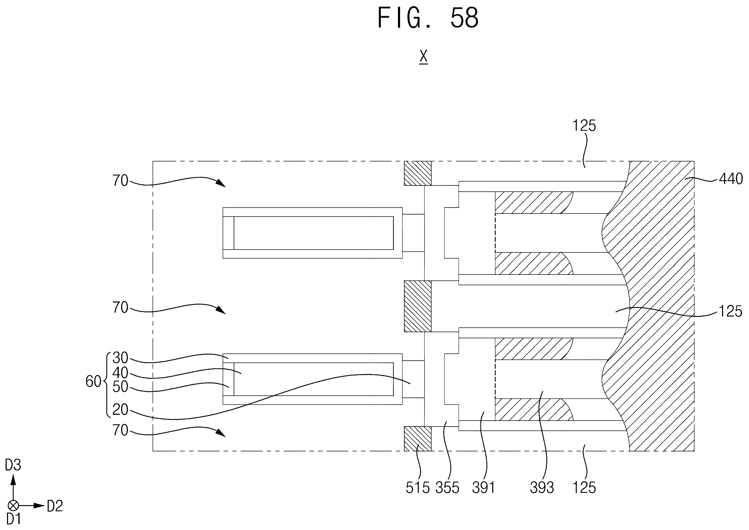

FIGS. 57 and 58 are vertical cross-sectional views illustrating a method of manufacturing a semiconductor device according to example embodiments. The method of manufacturing the semiconductor device includes processes substantially the same as or similar to those described with reference to FIGS. 7 to 55 and FIGS. 1 to 6, and thus, repeated explanations are omitted herein.

Referring to FIG. 57, processes substantially the same as or similar to those described with reference to FIGS. 7 to 50 may be performed. However, unlike the processes described with reference to FIGS. 49 and 50, the sidewalls of the channels 125 may be formed to protrude relative to the second sidewalls of the etch stop patterns 355.

Referring to FIG. 58, unlike the processes described with reference to FIG. 51, n-type impurities or p-type impurities may be doped by performing, for example, a Gas Phase Doping process, on the second end portions of the channels 125. Accordingly, the ohmic contacts 515 may be formed at the second end portions of the channels 125.

Referring back to FIG. 56, the manufacture of the semiconductor device may be completed by performing processes substantially the same as or similar to those described with reference to FIGS. 52 to 55 and FIGS. 1 to 6.

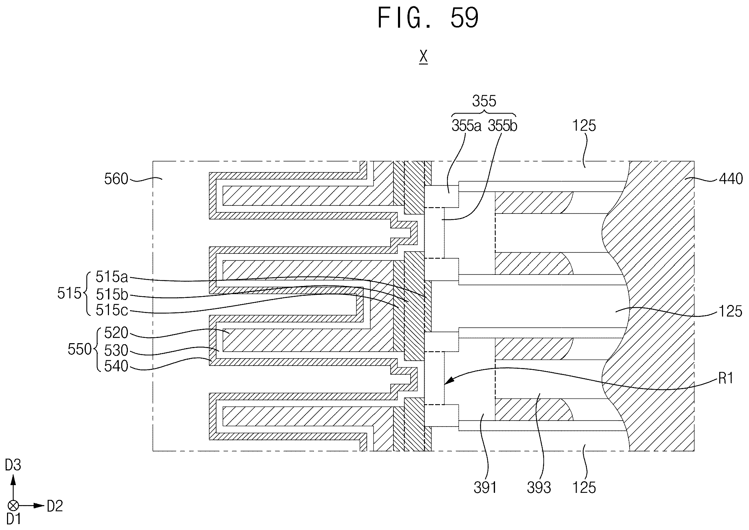

FIG. 59 is a vertical cross-sectional view illustrating a semiconductor device according to example embodiments, corresponding to FIG. 5. The semiconductor device is substantially the same as or similar to those described with reference to FIGS. 1 to 6 except for the shape of each of the first capacitor electrodes 520, the dielectric patterns 530 and the second capacitor electrodes 540, and thus, repeated explanations are omitted herein.

Referring to FIG. 59, each of the first capacitor electrodes 520 may have, for example, a hollow cuboid exterior shape with an opening on a side opposite to a side contacting the ohmic contact 515.

The dielectric patterns 530 and the second capacitor electrode 540 may be sequentially stacked along the surfaces of the first capacitor electrodes 520.

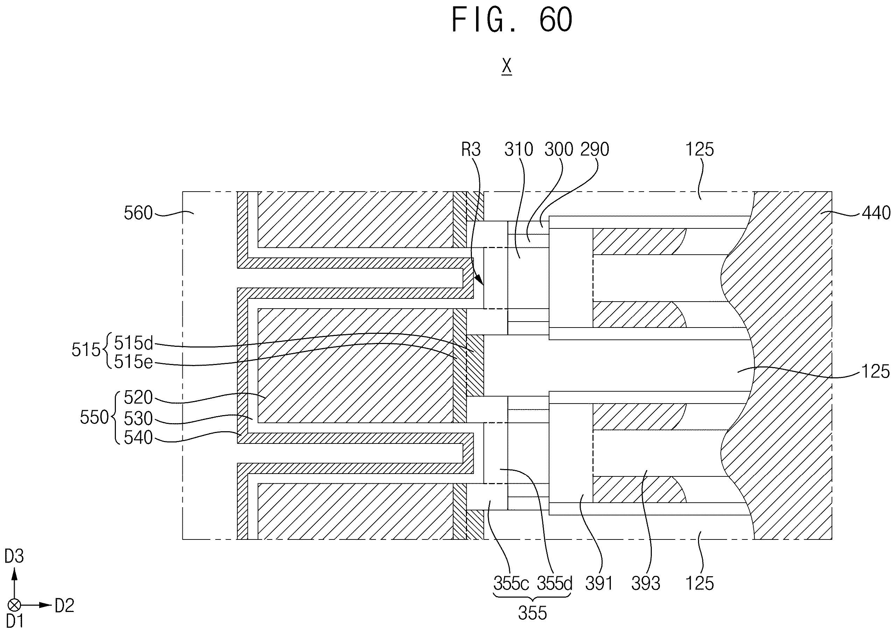

FIG. 60 is a vertical cross-sectional view illustrating a semiconductor device according to example embodiments, corresponding to FIG. 5. The semiconductor device is substantially the same as or similar to those described with reference to FIGS. 1 to 6 except for the position of the third division structure, the shape of the etch stop patterns 355, and the shape of the ohmic contacts 515, and thus, repeated explanations are omitted herein.

Referring to FIG. 60, the third division structure may fill the spaces between the channels 125 stacked in the third direction D3, between the upper surface of the substrate 100 and the lowermost channel 125, and between the uppermost channel 125 and the second mask 320.

The etch stop pattern 355 may include third portions 355c respectively surrounding the channels 125 and a fourth portion 355d surrounding the third portions 355c. In example embodiments, sidewalls in the second direction D2 of the third portions 355c of the etch stop pattern 355 that face the capacitors 550 may protrude in the second direction D2 as compared to a sidewall in the second direction D2 of the fourth portion 355d of the etch stop pattern 355 that faces the capacitors 550. Accordingly, third recesses R3 may be respectively disposed on the second sidewalls in the second direction D2 of the etch stop patterns 355 that faces capacitors 550.

In example embodiments, the ohmic contact 515 may include fourth and fifth portions 515d and 515e sequentially stacked on the second end portion in the second direction D2 of the channel 125. The fourth portion 515d of the ohmic contact 515 may overlap with the etch stop pattern 355 in the third direction D3.

In example embodiments, a fifth area of the fifth portion 515e of the ohmic contact 515 in a cross-section extending in the first and third directions D1 and D3 may be greater than the maximum area of the channel 125 in the cross-section extending in the first and third directions D1 and D3. In example embodiments, a fourth area of the fourth portion 515d of the ohmic contact 515 in a cross-section extending in the first and third directions D1 and D3 may be substantially the same to the maximum area of the channel 125 in the cross-section extending in the first and third directions D1, D3. In example embodiments, the fifth area may be larger than the fourth area, and the fourth area may be substantially the same as the maximum area of channel 125.

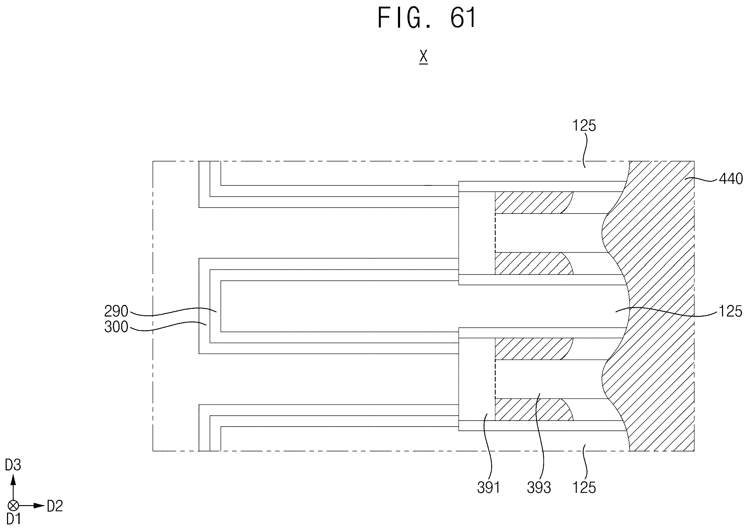

FIGS. 61 to 67 are vertical cross-sectional views illustrating a method of manufacturing a semiconductor device according to example embodiments. The method of manufacturing the semiconductor device includes processes substantially the same as or similar those described with reference to FIGS. 7 to 55 and FIGS. 1 to 6, and thus, repeated explanations are omitted herein.

Referring to FIG. 61, processes substantially the same as or similar to those illustrated with reference to FIGS. 7 to 27 may be performed. However, the processes described with reference to FIGS. 21 to 24 may not be performed. Accordingly, the etch stop patterns 355 may not be formed.

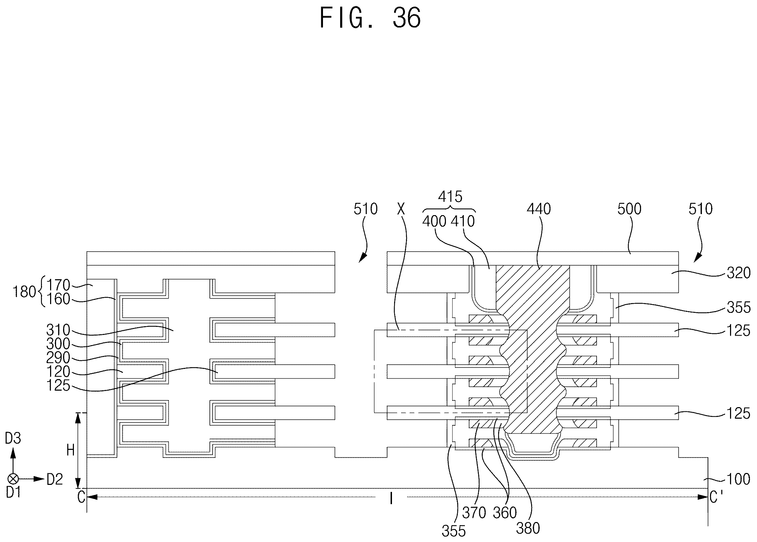

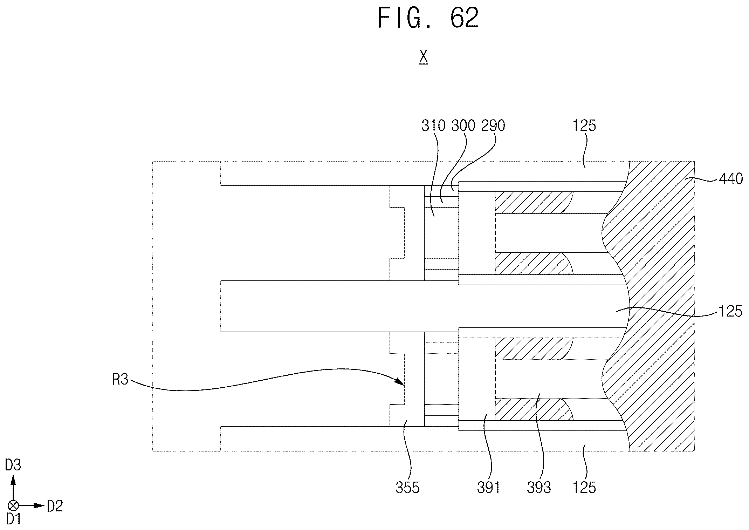

Referring to FIG. 62, processes substantially the same as or similar to those described with reference to FIGS. 28 to 38 may be performed. However, unlike the processes described with reference to FIGS. 36 to 38, the sidewalls of the third division structure rather than the etch stop patterns 355 may be exposed by the eleventh openings 510 and the fifth gaps.

Subsequently, the etch stop patterns 355 may be formed on the exposed sidewalls of the third division structures by performing processes substantially the same as or similar to those described with reference to FIGS. 21 to 24. However, a third recess R3 may be formed on the second sidewall in the second direction D2 of the etch stop pattern 355 exposed by the sixth gaps.

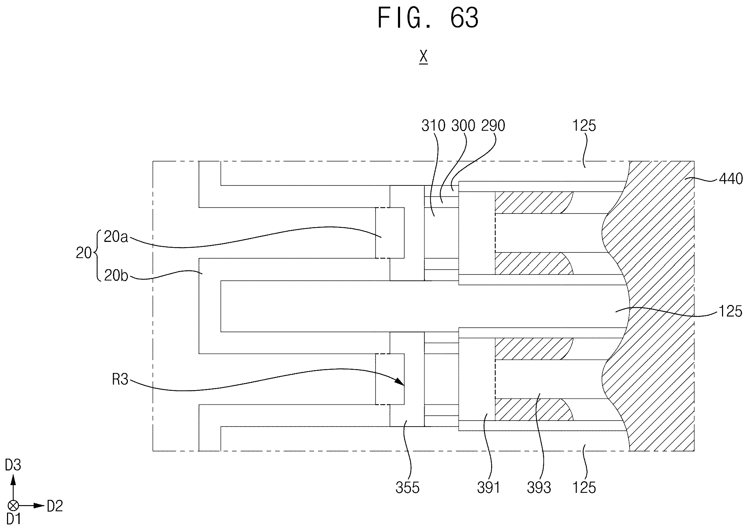

Referring to FIG. 63, the second sacrificial mold layer 20 may be formed by performing processes substantially the same as or similar to those described with reference to FIGS. 39 and 40. The second sacrificial mold layer 20 may be formed to include a first portion 20a formed in the third recess R3 and second portions 20b formed on the upper and lower surfaces and the sidewalls of the second end portions of the channels 125.

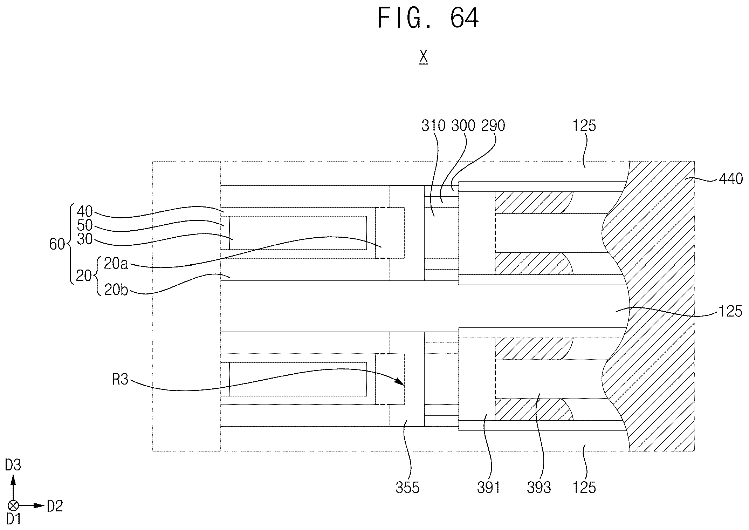

Referring to FIG. 64, the sacrificial mold layer structures 60 may be formed by performing processes substantially the same as or similar to those described with reference to FIGS. 41 to 46. However, as described above, the second sacrificial mold layer 20 of the sacrificial mold layer structure 60 may include the first portion 20a and the second portions 20b.

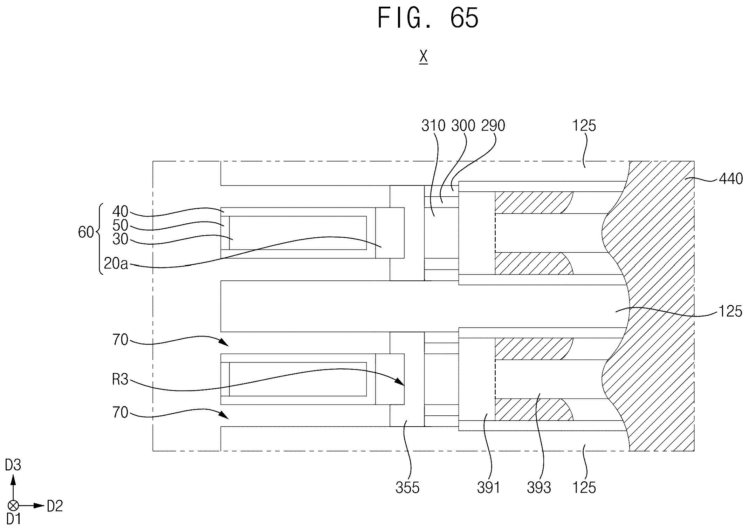

Referring to FIG. 65, the sixth gaps 70 may be formed by removing the second portions 20b of the second sacrificial mold layer 20 by performing processes substantially the same as or similar to those described with reference to FIGS. 47 and 48.

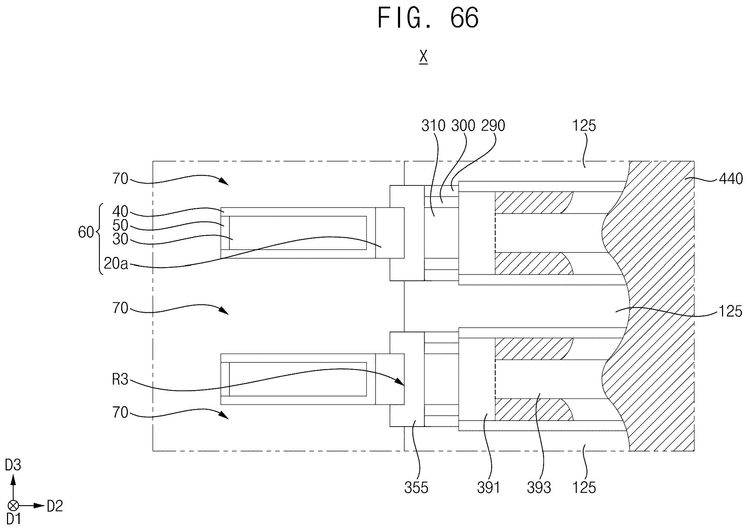

Referring to FIG. 66, the second end portions of the channels 125 may be partially removed by performing processes substantially the same as or similar to those described with reference to FIGS. 49 and 50.

In example embodiments, the sidewalls of the channels 125 may be formed to be recessed relative to a most protruding portion of the second sidewall of the etch stop pattern 355.

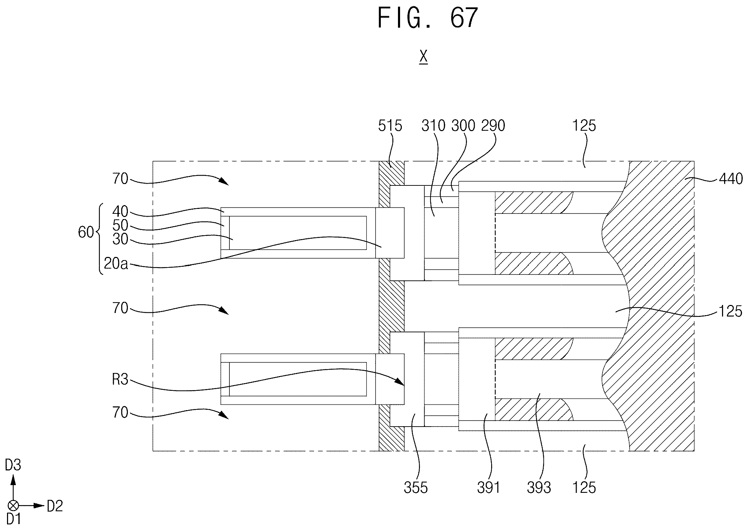

Referring to FIG. 67, the ohmic contacts 515 may be respectively formed on the sidewalls of the second end portions of the channels 125 by performing processes substantially the same as or similar to those described with reference to FIG. 51.

Referring back to FIG. 59, the manufacture of the semiconductor device may be completed by performing processes substantially the same as or similar to those described with reference to FIGS. 52 to 55 and FIGS. 1 to 6.

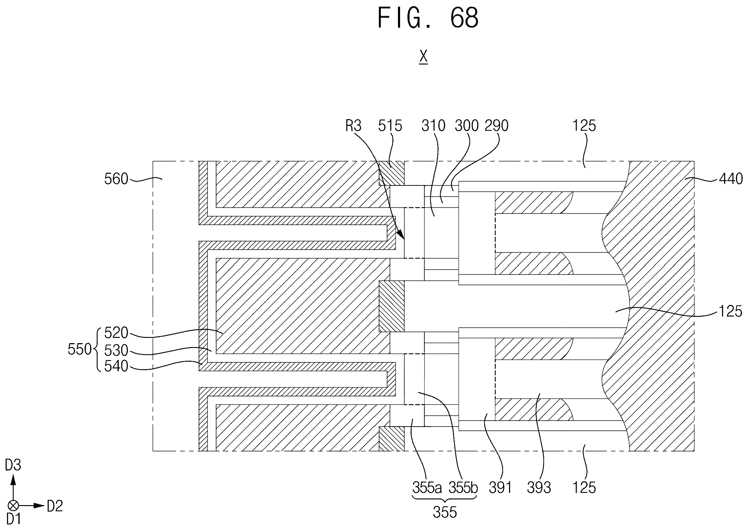

FIG. 68 is a vertical cross-sectional view illustrating a semiconductor device according to example embodiments, corresponding to FIG. 5. The semiconductor device is substantially the same as or similar to the semiconductor device described with reference to FIGS. 1 to 6 except for the shape of the ohmic contacts 515 and the shape of first capacitor electrodes 520, and thus, repeated explanations are omitted herein.

Referring to FIG. 68, similar to the semiconductor device described with reference to FIG. 56, the area of the ohmic contact 515, in a cross-section extending in the first and third directions D1 and D3 may be substantially the same to the maximum cross-sectional area of the channel 125 in the cross-section extending in the first and third directions D1 and D3.

In example embodiments, the first capacitor electrode 520 may cover the upper and lower surfaces and the sidewall of the ohmic contact 515 and the second sidewall of the etch stop pattern 355.

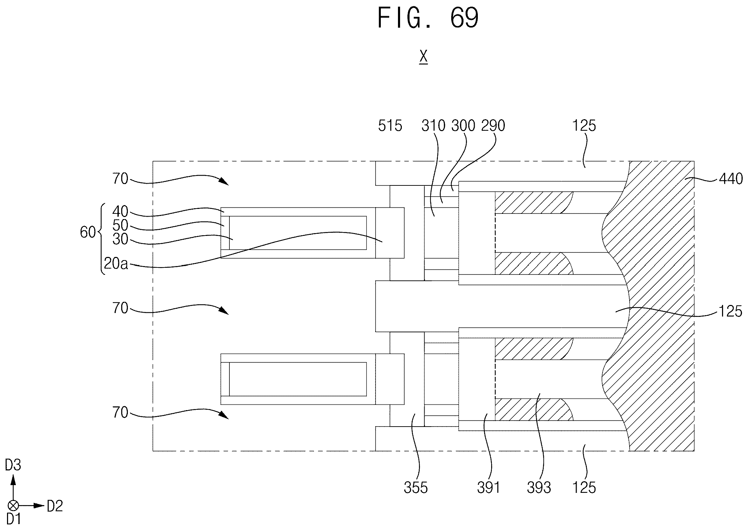

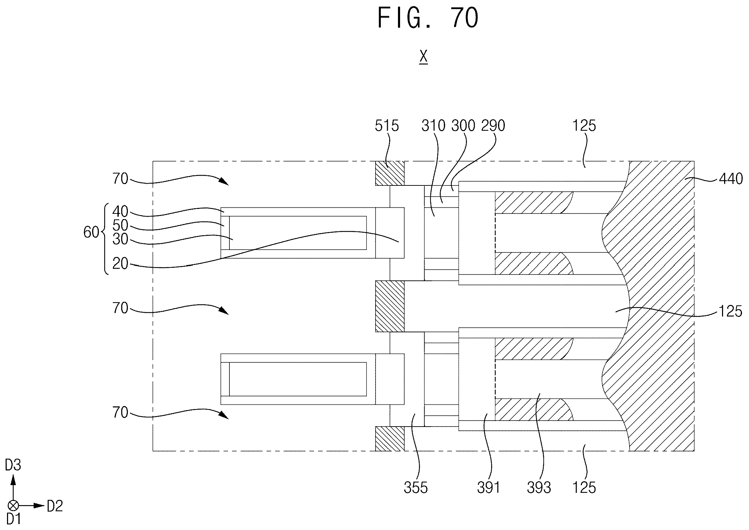

FIGS. 69 and 70 are vertical cross-sectional views illustrating a method of manufacturing a semiconductor device according to example embodiments. The method of manufacturing the semiconductor device includes processes substantially the same as or similar to those described with reference to FIGS. 7 to 55 and FIGS. 1 to 6, and thus, repeated explanations are omitted herein.

Referring to FIG. 69, processes substantially the same as or similar to those described with reference to FIGS. 7 to 50 may be performed. However, unlike the processes described with reference to FIGS. 49 and 50, the sidewalls of the channels 125 may be formed to protrude relative to the second sidewalls of the etch stop patterns 355.

Referring to FIG. 70, unlike the processes described with reference to FIG. 51, n-type impurities or p-type impurities may be doped by performing, for example, a Gas Phase Doping process, on the second end portions of the channels 125. Accordingly, the ohmic contacts 515 may be formed at the second end portions of the channels 125.

Referring back to FIG. 68, the manufacture of the semiconductor device may be completed by performing processes substantially the same as or similar to those described with reference to FIGS. 52 to 55 and FIGS. 1 to 6.

While the inventive concept has been shown and described with reference to example embodiments thereof, it will be apparent to those of ordinary skill in the art that various modifications in form and details may be made thereto without departing from the scope of the inventive concept as set forth by the following claims.

Embodiments are set out in the following clauses:
Clause 1. A semiconductor device comprising:
   channels on a substrate, each extending in a first horizontal direction that is parallel to an upper surface of the substrate, the channels disposed spaced apart from each other in a vertical direction perpendicular to the upper surface of the substrate;
   gate electrodes each extending in a second horizontal direction that intersects the first horizontal direction, each of the gate electrodes surrounding a corresponding one of first end portions of the channels;
   isolation patterns disposed between the gate electrodes;
   a bit line extending in the vertical direction and along sidewalls of the first end portions of the channels;
   conductive contacts, each conductive contact in contact with a corresponding one of second end portions of the channels and including a semiconductor material doped with charge carrier impurities;
   capacitors, each capacitor including a first capacitor electrode in contact with the conductive contacts; and
   an etch stop pattern disposed between the isolation patterns and the capacitors, the etch stop pattern surrounding the second end portions of the channels and including a metal oxide,
   wherein each of the channels has the maximum width in the vertical direction, each of the conductive contacts has the maximum width in the vertical direction, and each of the first capacitor electrodes has a first distance between upper and lower surfaces in the vertical direction,
   wherein the maximum width of the conductive contacts in the vertical direction is greater than the maximum width of the channel in the vertical direction and the first distance, and
   wherein the maximum width of the channel in the vertical direction is smaller than the maximum width of the channel in the vertical direction and the first distance.
Clause 2. The semiconductor device of clause 1, wherein the etch stop pattern has a plate shape extending in the vertical direction and the second horizontal direction.
Clause 3. The semiconductor device of clause 1 or clause 2,
   wherein the capacitors each includes a dielectric pattern and a second capacitor electrode sequentially stacked on:
      a corresponding one of the first capacitor electrodes,
      a corresponding one of the conductive contacts, and
      a sidewall of the etch stop pattern, and
   wherein the dielectric pattern contacts the sidewall of the etch stop pattern.
Clause 4. The semiconductor device of any of clauses 1 to 3, wherein
   wherein the etch stop pattern includes first portions and a second portion, each of the first portions surrounds a corresponding one of the channels, and the second portion connects the first portions to each other, and
   wherein the first portions of the etch stop pattern protrude toward the bit line in the second horizontal direction from the second portion of the etch stop pattern.
Clause 5. The semiconductor device of any of clauses 1 to 4,
   wherein the etch stop pattern includes first portions and a second portion, each of the first portions surrounds a corresponding one of the channels, and the second portion connects the first portions to each other, and
   wherein the first portions of the etch stop pattern protrude toward the bit line in the second horizontal direction from the second portion of the etch stop pattern.
Clause 6. The semiconductor device of any of clauses 1 to 5, wherein the etch stop pattern surrounds the channels in a vertical cross-sectional view.
Clause 7. The semiconductor device of any of clauses 1 to 6,
   wherein the etch stop pattern includes first portions and a second portion, each of the first portions surrounds a corresponding one of the channels, and the second portion connects the first portions to each other, and
   wherein the first portions of the etch stop pattern protrude in the first horizontal direction from the second portion of the etch stop pattern.

## Claims

1. A semiconductor device, comprising:
an etch stop pattern (355) on a substrate (100) and extending in a vertical direction (D3) perpendicular to an upper surface of the substrate (100), the etch stop pattern (355) comprising a metal oxide;
channels (125) spaced apart from each other in the vertical direction (D3), each extending in a first horizontal direction (D2) that is parallel to the upper surface of the substrate, each of the channels (125) extending partly into or extending fully through the etch stop pattern (355);
gate electrodes (370), each gate electrode (370) surrounding a corresponding one of the channels (125);
isolation patterns (397), each isolation pattern disposed between a corresponding pair of adjacent ones of the gate electrodes (370);
a bit line (440) extending in the vertical direction (D3) and along sidewalls of first end portions of the channels (125); and
capacitors (550) at sidewalls of respective second end portions of the channels (125),
wherein the etch stop pattern (355) and the gate electrodes (370) are spaced apart from each other by the isolation patterns (397).

2. The semiconductor device of claim 1, wherein the etch stop pattern (355) surrounds the channels (125) in a vertical cross-sectional view.

3. The semiconductor device of claim 1,
wherein the etch stop pattern (355) includes first portions (355a) and a second portion (355b), each of the first portions (355a) surrounds a corresponding one of the channels (125), and the second portion (355b) connects the first portions (355a) to each other, and
wherein the first portions (355a) of the etch stop pattern (355) protrude in the first horizontal direction (D2) from the second portion (355b) of the etch stop pattern (355).

4. The semiconductor device of claim 1,
wherein the capacitors (550) include respective first capacitor electrodes (520) at a side in the first horizontal direction (D2) of a corresponding one of the second end portions of the channels (125), and
wherein a first distance (d1) in the vertical direction (D3) between upper and lower surfaces of each of the first capacitor electrodes (520) is greater than the maximum width (w1) in the vertical direction (D3) of each of the channels (125).

5. The semiconductor device of claim 1, further comprising conductive contacts (515), each conductive contact (515) is in contact with a corresponding one of the second end portions of the channels (125),
wherein each of the conductive contacts (515) includes a semiconductor material doped with charge carrier impurities.

6. The semiconductor device of claim 5, wherein the maximum cross-sectional area of each of the conductive contacts (515) in a cross-section extending in the vertical direction (D3) and a second horizontal direction (D1) is greater than the maximum cross-section area of each of the channels (125) in a cross-section extending in the vertical direction (D3) and the second horizontal direction (D1), and
wherein the second horizontal direction (D1) is perpendicular to the first horizontal direction (D2).

7. The semiconductor device of claim 5,
wherein, in the first horizontal direction (D2), the conductive contacts (515) are further from the bit line (440) than the etch stop pattern (355),
wherein the maximum cross-sectional area of each of the conductive contacts (515) in a cross-section extending in the vertical direction (D3) and a second horizontal direction (D1) is the same as the maximum cross-section area of each of the channels (125) in a cross-section extending in the vertical direction (D3) and the second horizontal direction (D1), and
wherein the second horizontal direction (D1) is perpendicular to the first horizontal direction (D2).

8. The semiconductor device of claim 1, wherein the isolation patterns (397) include a material having an etch selectivity with respect to the etch stop pattern (355).

9. A semiconductor device comprising:
an etch stop pattern (355) on a substrate (100) and extending in a vertical direction (D3) perpendicular to an upper surface of the substrate;
a channel (125) extending in a first horizontal direction (D2) that is parallel to the upper surface of the substrate (100), the channel (125) extending partly into or extending fully through the etch stop pattern (355);
a gate electrode (370) surrounding the channel (125);
a bit line (440) extending in the vertical direction (D3) and along a sidewall of a first end portion of the channel (125); and
a capacitor (550) at a sidewall of a second end portion of the channel (125),
wherein the etch stop pattern (355) includes a first portion (355a) and a second portion (355b), the first portion (355a) surrounds the channel (125), and the second portion (355b) is integrally connected to the first portion (355a), and
wherein the first portion (355a) of the etch stop pattern (355) protrudes toward the capacitor (550) in the first horizontal direction (D2) from the second portion (355b) of the etch stop pattern (355).

10. The semiconductor device of claim 9, wherein the etch stop pattern (355) includes a metal oxide.

11. The semiconductor device of claim 9,
wherein the capacitor (550) includes a first capacitor electrode (520) at a sidewall in the first horizontal direction (D2) of the second end portion of the channel (125), a dielectric pattern (530) and a second capacitor electrode (540),
wherein the first capacitor electrode (520), the dielectric pattern (530) and the second capacitor electrode (540) are sequentially stacked, and
wherein the dielectric pattern (530) contacts the etch stop pattern (355).

12. The semiconductor device of claim 9, wherein the capacitor (550) includes a first capacitor electrode (520) at a sidewall in the first horizontal direction (D2) of the second end portion of the channel (125), and
wherein a first distance (d1) in the vertical direction (D3) between upper and lower surfaces of the first capacitor electrode (520) is greater than the maximum width (w1) in the vertical direction (D3) of the channel (125).

13. The semiconductor device of claim 9, further comprising a conductive contact (515) on a sidewall of the second end portion of the channel (125),
wherein the conductive contact (515) includes a semiconductor material doped with charge carrier impurities.

14. The semiconductor device of claim 13,
wherein the conductive contact (515) includes a first portion (515a) and a second portion (515b), the first and second portions (515a, 515b) of the conductive contact (515) is a single continuous homogenous body, and the first portion (515a) overlaps in the vertical direction (D3) with the etch stop pattern (355),
wherein a first cross-sectional area of the first portion (515a) in a cross-section extending in the vertical direction (D3) and a second horizontal direction (D1) is smaller than a second cross-sectional area of the second portion (515b) in a cross-section extending in the vertical direction (D3) and the first horizontal direction (D2), and
wherein the second horizontal direction (D1) is perpendicular to the first horizontal direction (D2).

15. A semiconductor device comprising:
channels (125) on a substrate (100), each extending in a first horizontal direction (D2) that is parallel to an upper surface of the substrate (100), the channels (125) disposed spaced apart from each other in a vertical direction (D3) perpendicular to the upper surface of the substrate (100);
gate electrodes (370) each extending in a second horizontal direction (D1) that intersects the first horizontal direction (D2), each of the gate electrodes (370) surrounding a corresponding one of first end portions of the channels (125);
isolation patterns (397) disposed between the gate electrodes (370);
a bit line (440) extending in the vertical direction (D3) and along sidewalls of the first end portions of the channels (125);
conductive contacts (515), each conductive contact (515) in contact with a corresponding one of second end portions of the channels (125) and including a semiconductor material doped with charge carrier impurities;
capacitors (550), each capacitor (550) including a first capacitor electrode (520) in contact with the conductive contacts (515); and
an etch stop pattern (355) disposed between the isolation patterns (397) and the capacitors (550), the etch stop pattern (355) surrounding the second end portions of the channels (125) and including a metal oxide,
wherein each of the channels (125) has the maximum width in the vertical direction (D3), each of the conductive contacts (515) has the maximum width in the vertical direction (D3), and each of the first capacitor electrodes (520) has a first distance (d1) between upper and lower surfaces in the vertical direction (D3),
wherein the maximum width of the conductive contacts (515) in the vertical direction (D3) is greater than the maximum width of the channel (125) in the vertical direction (D3) and the first distance (d1), and
wherein the maximum width of the channel (125) in the vertical direction (D3) is smaller than the maximum width of the conductive contacts (515) in the vertical direction and the first distance (d1).
